(19) Europäisches Patentamt
European Patent Office
Office européen des brevets

(11) EP 1 703 323 A1

(12) EUROPEAN PATENT APPLICATION

(43) Date of publication:
20.09.2006 Bulletin 2006/38

(51) Int Cl.:
*G03F 7/031* (2006.01)

(21) Application number: 06005628.0

(22) Date of filing: 20.03.2006

(84) Designated Contracting States:
AT BE BG CH CY CZ DE DK EE ES FI FR GB GR HU IE IS IT LI LT LU LV MC NL PL PT RO SE SI SK TR
Designated Extension States:
AL BA HR MK YU

(30) Priority: 18.03.2005 JP 2005079645

(71) Applicant: FUJI PHOTO FILM CO., LTD.
Minami-Ashigara-shi, Kanagawa (JP)

(72) Inventors:
- Ishiji, Yohei, c/o Fuji Photo Film Co, Ltd Haibara-gun Shizuoka (JP)
- Shibuya, Akinori, c/o Fuji Photo Film Co, Ltd Haibara-gun Shizuoka (JP)

(74) Representative: HOFFMANN EITLE
Patent- und Rechtsanwälte
Arabellastrasse 4
81925 München (DE)

# (54) Photosensitive composition, image-recording material and image-recording method

(57) A photosensitive composition comprising: a hexaarylbiimidazole compound represented by the following formula (I) as defined herein;a sensitizing dye having an absorption maximum in a wavelength range of from 350 to 850 nm; and an addition-polymerizable compound capable of reacting by at least one of a radical and an acid.

EP 1 703 323 A1

## Description

### FIELD OF THE INVENTION

The present invention relates to a photosensitive composition capable of utilizing for image-recording materials, for example, three-dimensional photo-modeling, holography, lithographic printing plate precursors, color proofs, photoresists or color filters, and photo-curable resin materials, for example, ink, paint or adhesive, and an image recording method using the photosensitive composition. In particular, it relates to a photosensitive composition preferably used in a lithographic printing plate precursor that is capable of being subjected to a so-called direct plate-making, in which the plate-making is directly conducted based on digital signals, for example, from a computer using various kinds of lasers, and an image recording method using the photosensitive composition.

### BACKGROUND OF THE INVENTION

A solid laser, semiconductor laser and gas laser having a large output and a small size, which radiate an ultraviolet ray, visible light or infrared ray having a wavelength of 300 to 1,200 nm, have become easily available, and these lasers are very useful for a recording light source used in the direct plate-making based on digital signals, for example, from a computer. Various investigations on recording materials sensitive to various laser beams have been made. Representative examples thereof include recording materials capable of being recorded with a infrared laser having a wavelength of 760 nm or longer, for example, positive-working recording materials described in U.S. Patent 4,708,925 and acid catalyst crosslinking type negative-working recording materials described in JP-A-8-276558 (the term "JP-A" as used herein means an "unexamined published Japanese patent application"), and recording materials responsive to an ultraviolet ray or visible light laser having a wavelength of 300 to 700 nm, for example, radical polymerization type negative-working recording materials described in U.S. Patent 2,850,445 and JP-B-44-20189 (the term "JP-B" as used herein means an examined Japanese patent publication").

A subject common to all of these image-recording materials is that how an ON-OFF of the image can be enlarged in the irradiated area and unirradiated area with various energies described above. In other words, the subject is to satisfy both of high sensitivity and preservation stability of the image-recording material. Photo radical polymerization systems are ordinarily highly sensitive but their sensitivities severely decrease due to polymerization inhibition caused by oxygen in the atmosphere. Thus, means of providing an oxygen blocking layer on the image-recording layer is taken. However, the provision of oxygen blocking layer may adversely cause the formation of fog due to polymerization in the dark or the like, resulting in degradation of the preservation stability. It is difficult for the high sensitivity to consist with the preservation stability, and satisfactory results have not been obtained by hitherto known techniques. Therefore, novel techniques to solve these problems have been desired.

On the other hand, photoinitiators of high sensitivity are described, for example, in Bruce M. Monroe et al., Chemical Reviews, 93, 435 (1993), and R. S. Davidson, Journal of Photochemistry and Photobiology A: Chemistry, 73, 81 (1993).

In essence, the photosensitive compositions heretofore proposed do not fully satisfy all of the sensitivity, preservation stability, workability and economy, when they are used as an image-recording material for scanning exposure suited to a CTP system. Therefore, development of a photosensitive composition fully satisfying all of these terms has been required.

### SUMMARY OF THE INVENTION

Therefore, an object of the present invention is to provide a highly sensitive photosensitive composition suitable for use as an image-recording material for scanning exposure suited to a CTP system, which is excellent in the sensitivity, plate-making property, preservation stability, workability and economy, and to provide a photosensitive composition suitable for an image-recording material highly sensitive to an emission wavelength of an inexpensive short-wavelength semiconductor laser. In particular, another object of the invention is to provide a photosensitive composition preferably used for a lithographic printing plate precursor capable of being directly plate-made based on digitalized data, for example, from a computer by recording using a solid laser or a semiconductor laser radiating an ultraviolet ray, visible light or infrared ray. A still another object of the invention is to provide a photosensitive composition using a novel photopolymerization initiation system having high sensitivity over a wide wavelength range of 350 to 850 nm and excellent workability under a yellow lamp.

A further object of the invention is to provide an image-recording material and an image-recording method using the above-described photosensitive composition.

As a result of intensive investigations to achieve the above-described objects of the invention, the inventors have found that when a composition containing a sensitizing dye and a hexaarylbiimidazole compound having a specific

structure in combination, a photopolymerization initiation system remarkably excellent in the sensitivity, plate-making property, preservation stability and workability and suitable for exposure in a wavelength range from 350 to 850 nm, particularly, from 350 to 450 nm is obtained. Also, it has been found that an image-recording material using a photosensitive composition comprising the photopolymerization initiation system and an addition-polymerizable compound capable of reacting by a radical or an acid, specifically, an addition-polymerizable compound having an ethylenically unsaturated double bond can provide a lithographic printing plate precursor having sufficient sensitivity to an emission wavelength of a short wavelength semiconductor laser and capable of being handled even under a bright safe light to complete the invention.

Specifically, the present invention includes the following items.

(1) A photosensitive composition comprising (A) a hexaarylbiimidazole compound represented by formula (I) shown below, (B) a sensitizing dye having an absorption maximum (λmax) in a wavelength range of 350 to 850 nm, and (C) an addition-polymerizable compound capable of reacting by at least one of a radical and an acid:

Formula (I):

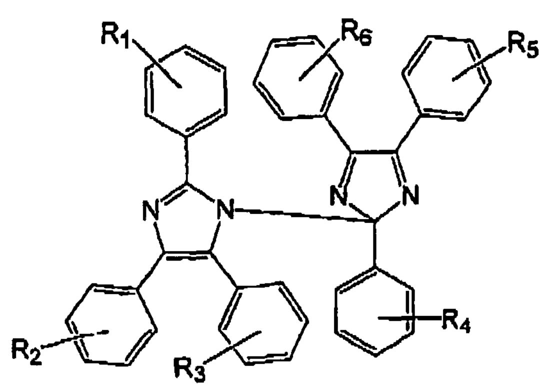

In formula (I), $R_1$ to $R_6$ each independently represents a hydrogen atom or a monovalent non-metallic atomic group, or $R_1$ to $R_3$ or $R_4$ to $R_6$ may be combined with each other to form an aliphatic or aromatic ring, provided that the aromatic rings (rings substituted with $R_1$ or $R_4$) of the 2-positions have electron donating groups having a negative Hammette' s substituent constant on the ortho-positions and/or metha-positions thereof respectively or the aromatic rings (rings substituted with $R_2$, $R_3$, $R_5$ or $R_6$) of the 4-positions and 5-positions have electron withdrawing groups having a positive Hammette's substituent constant on the metha-positions and/or para-positions thereof respectively.

2 The photosensitive composition as described in (1) above, wherein the hexaarylbiimidazole compound represented by formula (I) has electron donating groups having a negative Hammette's substituent constant on the ortho-positions and/or metha-positions of the aromatic rings (rings substituted with $R_1$ or $R_4$) of the 2-positions respectively and electron withdrawing groups having a positive Hammette's substituent constant on the metha-positions and/or para-positions of the aromatic rings (rings substituted with $R_2$, $R_3$, $R_5$ or $R_6$) of the 4-positions and 5-positions respectively.

(3) An image-recording material comprising a support having thereon a photosensitive layer containing the photosensitive composition as described in (1) or (2) above.

(4) An image-recording method comprising conducting scanning exposure to an image-recording material comprising a support having thereon a photosensitive layer containing the photosensitive composition as described in (1) or (2) above using a laser light source having a wavelength of 350 to 450 nm.

The photosensitive composition of the invention is characterized by containing as the essential components, the hexaarylbiimidazole compound (initiator) having electron donating groups having a negative Hammette's substituent constant on the ortho-positions and/or metha-positions of the aromatic rings (rings substituted with $R_1$ or $R_4$) of the 2-positions respectively and/or electron withdrawing groups having a positive Hammette's substituent constant on the metha-positions and/or para-positions of the aromatic rings (rings substituted with $R_2$, $R_3$, $R_5$ or $R_6$) of the 4-positions and 5-positions respectively, the sensitizing dye having an absorption maximum (λmax) in a specific wavelength range and the addition-polymerizable compound capable of reacting by at least one of a radical and an acid.

The photosensitive composition of the invention has a feature in that it has both of high sensitivity and high

plate-making property, preservation stability and workability. The characteristics of the invention are specifically described in detail below.

As a conventional hexaarylbiimidazole compound commercially available, the compound shown below, abbreviated as LD-5 (o-Cl HABI), is known. This compound is a highly sensitive initiator that functions as an electron acceptor for a sensitizing dye to generate an active radical. However, maybe due to insufficiency of thermal stability, the compound may generate a slight amount of an active radical according to a homolitic cleavage of the C-N bond at a drying step in the plate-making of the photosensitive layer to cause development failure. Therefore, improvement thereof has been required.

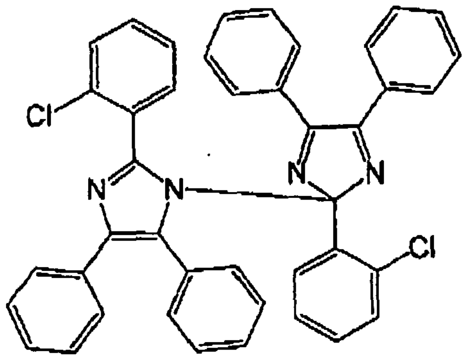

LD-5

In the photosensitive composition of the invention, the hexaarylbiimidazole compound which is represented by formula (I) described above and which has electron donating groups having a negative Hammette' s substituent constant on the ortho-positions and/or metha-positions of the aromatic rings (rings substituted with $R_1$ or $R_4$) of the 2-positions respectively and/or electron withdrawing groups having a positive Hammette's substituent constant on the metha-positions and/or para-positions of the aromatic rings (rings substituted with $R_2$, $R_3$, $R_5$ or $R_6$) of the 4-positions and 5-positions respectively, is used. It is believed that as to the compound, the introduction of the electron donating groups into the aromatic rings of the 2-positions or the introduction of the electron withdrawing groups into the aromatic rings of the 4-positions and 5-positions may increase active energy and restrain the thermal cleavage of the C-N bond at the drying step by heating in the plate-making to prevent the development defect, although the reason for this is not quite clear. It is also believed that the compound has high preservation stability after the plate-making because the generation of a slight amount of an active radical according to the cleavage of bond is prevented.

The photosensitive composition of the invention has a sufficient sensitivity suitable for scanning exposure by a short wavelength semiconductor laser, for example, InGaN, and is excellent in the plate-making property, preservation stability, workability and economy, and is preferably used for a material for forming a photosensitive layer of a lithographic printing plate precursor.

DETAILED DESCRIPTION OF THE INVENTION

The embodiments according to the invention will be described in more detail below.

First, the photosensitive composition of the invention is described below.

The photosensitive composition of the invention contains a photopolymerization initiation system comprising the specific initiator and the specific sensitizing dye and an addition-polymerizable compound.

[Photopolymerization Initiation System]

The photopolymerization initiation system for use in the photosensitive composition of the invention comprises the sensitizing dye having an absorption maximum (λmax) in a wavelength range of 350 to 850 nm and the hexaarylbiimidazole compound (initiator) represented by formula (I) shown below having electron donating groups having a negative Hammette's substituent constant on the ortho-positions and/or metha-positions of the aromatic rings (rings substituted with $R_1$ or $R_4$) of the 2-positions respectively and/or electron withdrawing groups having a positive Hammette's substituent constant on the metha-positions and/or para-positions of the aromatic rings (rings substituted with $R_2$, $R_3$, $R_5$ or $R_6$) of the 4-positions and 5-positions respectively.

Formula (I):

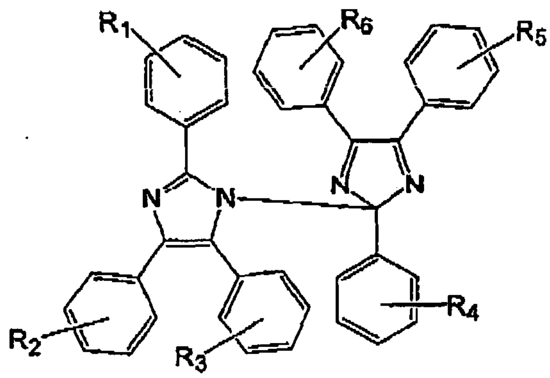

In formula (I), $R_1$ to $R_6$ each independently represents a hydrogen atom or a monovalent non-metallic atomic group, or $R_1$ to $R_3$ or $R_4$ to $R_6$ may be combined with each other to form an aliphatic or aromatic ring.

<(A) Hexaarylbiimidazole compound (initiator)>

The hexaarylbiimidazole compound constituting the photopolymerization initiation system for use in the photosensitive composition according to the invention includes a compound (compound defined in Claim 1, hereinafter also referred to as an "imidazole compound A") represented by formula (I) shown above having electron donating groups having a negative Hammette's substituent constant on the ortho-positions and/or metha-positions of the aromatic rings (rings substituted with $R_1$ or $R_4$) of the 2-positions respectively or electron withdrawing groups having a positive Hammette' s substituent constant on the metha-positions and/or para-positions of the aromatic rings (rings substituted with $R_2$, $R_3$, $R_5$ or $R_6$) of the 4-positions and 5-positions, respectively and a compound (compound defined in Claim 2, hereinafter also referred to as an "imidazole compound B") represented by formula (I) shown above having electron donating groups having a negative Hammette' s substituent constant on the ortho-positions and/or metha-positions of the aromatic rings (rings substituted with $R_1$ or $R_4$) of the 2-positions respectively and electron withdrawing groups having a positive Hammette's substituent constant on the metha-positions and/or para-positions of the aromatic rings (rings substituted with $R_2$, $R_3$, $R_5$ or $R_6$) of the 4-positions and 5-positions respectively.

Now, the imidazole compounds A and B of hexaarylbiimidazole type represented by formula (I) are described in greater detail below.

In formula (I), $R_1$ to $R_3$ and $R_4$ to $R_6$ each preferably represents a hydrogen atom, a substituted or unsubstituted alkyl group, alkoxy group, halogen atom, cyano group, alkoxycarbonyl group, alkylketone group, aryl group or heteroaryl group.

Preferred examples of $R_1$ to $R_3$ and $R_4$ to $R_6$ are specifically described below. Preferred examples of the alkyl group include a straight chain, branched or cyclic alkyl group having from 1 to 20 carbon atoms. Specific examples thereof include a methyl group, an ethyl group, a propyl group, a butyl group, a pentyl group, a hexyl group, a heptyl group, an octyl group, a nonyl group, a decyl group, an undecyl group, a dodecyl group, a tridecyl group, a hexadecyl group, an octadecyl group, an eicosyl group, an isopropyl group, an isobutyl group, a sec-butyl group, a tert-butyl group, an isopentyl group, a neopentyl group, a 1-methylbutyl group, an isohexyl group, a 2-ethylhexyl group, a 2-methylhexyl group, a cyclohexyl group, a cyclopentyl group and a 2-norbornyl group. Of the alkyl groups, a straight chain alkyl group having from 1 to 12 carbon atoms, a branched alkyl group having from 3 to 12 carbon atoms and a cyclic alkyl group having from 5 to 10 carbon atoms are more preferred.

The substituent for the substituted alkyl group includes a monovalent non-metallic atomic group exclusive of a hydrogen atom. Preferred examples of the substituent for the alkyl group include a halogen atom (e.g., -F, -Br, -Cl or -I), a hydroxy group, an alkoxy group, an aryloxy group, a mercapto group, an alkylthio group, an arylthio group, an alkyldithio group, an aryldithio group, an amino group, an N-alkylamino group, an N,N-dialkylamino group, an N-arylamino group, an N,N-diarylamino group, an N-alkyl-N-arylamino group, an acyloxy group, a carbamoyloxy group, an N-alkylcarbamoyloxy group, an N-arylaarbamoyloxy group, an N,N-dialkylcarbamoyloxy group, an N,N-diarylcarbamoyloxy group, an N-alkyl-N-arylcarbamoyloxy group, an alkylsulfoxy group, an arylsulfoxy group, an acyloxy group, an acylthio group, an acylamino group, an N-alkylacylamino group, an N-arylacylamino group, a ureido group, an N'-alkylureido group, an N',N'-dialkylureido group, N'-arylureido group, an N',N'-diarylureido group, an N'-alkyl-N'-arylureido group, an N-alkylureido group, N-arylureido group, an N'-alkyl-N-alkylureido group, an N'-alkyl-N-arylureido group, an N',N'-dialkyl-N-alkylureido group, an N',N'-dialkyl-N-arylureido group, an N'-aryl-N-alkylureido group, an N'-aryl-N-arylureido

group, an N',N'-diaryl-N-alkylureido group, an N',N'-diaryl-N-arylureido group, an N'-alkyl-N'-aryl-N-alkylureido group, an N'-alkyl-N'-axyl-N-arylureido group, an alkoxycarbonylamino group, an aryloxycarbonylamino group, an N-alkyl-N-alkoxycarbonylamino group, an N-alkyl-N-aryloxycarbonylamino group, an N-aryl-N-alkoxycarbonylantino group, an N-aryl-N-aryloxycarbonylamino group, a formyl group, an acyl group, a carboxy group, an alkoxycarbonyl group, an aryloxycarbonyl group, a carbamoyl group, an N-alkylcarbamoyl group, an N,N-dialkylcarbamoyl group, an N-arylcarbamoyl group, an N,N-diarylcarbamoyl group, an N-alkyl-N-arylcarbamoyl group, an alkylsulfinyl group, an arylsulfinyl group, an alkylsulfonyl group, an arylsulfonyl group, a sulfo group ($-SO_3H$) and a conjugate base group thereof (hereinafter, referred to as a sulfonato group), an alkoxysulfonyl group, an aryloxysulfonyl group, a sulfinamoyl group, an N-alkylsulfinamoyl group, an N,N-dialkylsulfinamoyl group, an N-arylsulfinamoyl group, an N,N-diarylsulfinamoyl group, an N-alkyl-N-arylsulfinamoyl group, a sulfamoyl group, an N-alkylsulfamoyl group, an N,N-dialkylsulfamoyl group, an N-arylsulfamoyl group, an N,N-diarylsulfamoyl group, an N-alkyl-N-arylsulfamoyl group, a phosphono group ($-PO_3H_2$) and a conjugate base group thereof (hereinafter, referred to as a phosphonato group), a dialkylphosphono group ($-PO_3(alkyl)_2$), a diarylphosphono group ($-PO_3(aryl)_2$), an alkylarylphosphono group ($-PO_3(alkyl)(aryl)$), a monoalkylphosphono group ($-PO_3H(alkyl)$) and a conjugate base group thereof (hereinafter, referred to as an alkylphosphonato group), a monoarylphosphono group ($-PO_3H(aryl)$) and a conjugate base group thereof (hereinafter, referred to as an arylphosphonato group), a phosphonoxy group ($-OPO_3H_2$) and a conjugate base group thereof (hereinafter, referred to as a phosphonatoxy group), a dialkylphosphonoxy group ($-OP_O(alkyl)_2$), a diarylphosphonoxy group ($-OPO_3(aryl)_2$), an alkylarylphosphonoxy group ($-OPO_3(alkyl)(aryl)$), a monoalkylphosphonoxy group ($-OPO_3H$ (alkyl)) and a conjugate base group thereof (hereinafter, referred to as an alkylphosphonatoxy group), a monoarylphosphonoxy group ($-OPO_3H(aryl)$) and a conjugate base group thereof (hereinafter, referred to as an arylphosphonatoxy group), a cyano group, a nitro group, an aryl group, a heteroaryl group, an alkenyl group, an alkynyl group and a silyl group.

Specific examples of the alkyl group in the substituents include those described above. The substituents may further have a substituent.

Preferred examples of the alkoxy group include a methoxy group and an ethoxy group. Examples of the halogen atom preferably include a chlorine atom and a bromine atom, and more preferably a chlorine atom. Examples of the alkoxycarbonyl group preferably include a methoxycarbonyl group and an ethoxycarbonyl group, and more preferably a methoxycarbonyl group.

Preferred specific examples of the aryl group for each of $R_1$ to $R_3$ and $R_4$ to $R_6$ include a condensed ring of one to three benzene rings and a condensed ring of a benzene ring and a 5-membered unsaturated ring. Specific preferred examples of the aryl group include a phenyl group, a naphthyl group, an anthryl group, a phenanthryl group, an indenyl group, an acenaphthenyl group and a fluorenyl group. Among them, a phenyl group and a naphthyl group are more preferred.

Preferred examples of the alkyl moiety in the alkylketone group include a straight chain, branched or cyclic alkyl group having from 1 to 20 carbon atoms. Specific examples thereof include a methyl group, an ethyl group, a propyl group, a butyl group, a pentyl group, a hexyl group, a heptyl group, an octyl group, a nonyl group, a decyl group, an undecyl group, a dodecyl group, a tridecyl group, a hexadecyl group, an octadecyl group, an eicosyl group, an isopropyl group, an isobutyl group, a sec-butyl group, a tert-butyl group, an isopentyl group, a neopentyl group, a 1-methylbutyl group, an isohexyl group, a 2-ethylhexyl group, a 2-methylhexyl group, a cyclohexyl group, a cyclopentyl group and a 2-norbornyl group. Of the alkyl groups, a straight chain alkyl group having from 1 to 12 carbon atoms, a branched alkyl group having from 3 to 12 carbon atoms and a cyclic alkyl group having from 5 to 10 carbon atoms are more preferred.

Preferred specific examples of the substituted aryl group for each of $R_1$ to $R_3$ and $R_4$ to $R_6$ include groups having a monovalent non-metallic atomic group (exclusive of a hydrogen atom), as a substituent, on the ring-forming carbon atom of the above-described aryl group. Preferred Examples of the substituent include the above-described alkyl and substituted alkyl group and the substituents for the substituted alkyl group described above. Specific preferred examples of the substituted aryl group include a biphenyl group, a tolyl group, a xylyl group, a mesityl group, a cumenyl group, a chlorophenyl group, a bromophenyl group, a fluorophenyl group, a chloromethylphenyl group, a trifluoromethylphenyl group, a hydroxyphenyl group, a methoxyphenyl group, a methoxyethoxyphenyl group, an allyloxyphenyl group, a phenoxyphenyl group, a methylthiophenyl group, a tolylthiophenyl group, a phenylthiophenyl group, an ethylaminophenyl group, a diethylaminophenyl group, a morpholinophenyl group, an acetyloxyphenyl group, a benzoyloxyphenyl group, an N-cyclohexylcarbamoyloxyphenyl group, an N-phenylcarbamoyloxyphenyl group, an acetylaminophenyl group, an N-methylbenzoylaminophenyl group, a carboxyphenyl, methoxycarbonylphenyl group, an allyloxycarbonylphenyl group, a chlorophenoxycarbonylphenyl group, a carbamoylphenyl group, an N-methylcarbamoylphenyl group, an N,N-dipropylcarbamoylphenyl group, an N-(methoxyphenyl)carbamoylphenyl group, an N-methyl-N- (sulfophenyl) carbamoylphenyl group, a sulfophenyl group, a sulfonatophenyl group, a sulfamoylphenyl group, an N-ethylsulfamoylphenyl group, an N,N-dipropylsulfamoylphenyl group, an N-tolylsulfamoylphenyl group, an N-methyl-N-(phosphonophenyl)sulfamoylphenyl group, a phosphonophenyl group, a phosphonatophenyl group, a diethylphosphonophenyl group, a diphenylphosphonophenyl group, a methylphosphonophenyl group, a methylphosphonatophenyl group, a tolylphosphonophenyl group, a tolylphosphonatophenyl group, an allylphenyl group, a 1-propenylmethylphenyl group, a 2-butenylphenyl group,

a 2-methylallylphenyl group, a 2-methylpropenylphenyl group, a 2-propynylphenyl group, a 2-butynylphenyl group and a 3-butynylphenyl group.

The heteroaryl group includes groups derived from monocyclic or polycyclic aromatic ring containing at least one member selected from a nitrogen atom, an oxygen atom and a sulfur atom. Examples of the heteroaryl ring in particularly preferable heteroaryl group include thiophene, thiathrene, furan, pyran, isobenzofuran, chromene, xanthene, phenoxazine, pyrrole, pyrazole, isothiazole, isoxazole, pyrazine, pyrimidine, pyridazine, indolizine, isoindolizine, indole, indazole, purine, quinolizine, isoquinoline, phthalazine, naphthylidine, quinazoline, cinnoline, pteridine, carbazole, carboline, phenanthrene, acridine, perimidine, phenanthroline, phthalazine, phenarsazine, phenoxazine, furazane and phenoxazine. These rings may be benzo-fused or may have a substituent.

Of the substituents described above, preferable substituents can be selected to use with reference to the Hammette's substituent constants of respective substituents.

According to the invention, in the preferable hexaarylbiimidazole compound, the substituents on the aromatic rings on the 2-position are substituents having a negative Hamette' s substituent constant (electron donating type), and the substituent position is an ortho position or a metha position, preferably an ortho position. The substituents on the aromatic rings on the 4-position and 5-position are substituents having a positive Hammette' s substituent constant (electron withdrawing type), and the substituent position is a metha position or a para position, preferably a para position.

As examples of the hexaarylbiimidazole compound having a preferable structure, Compounds (T-1) to (T-9) shown below are set forth, but the invention should not be construed as being limited thereto.

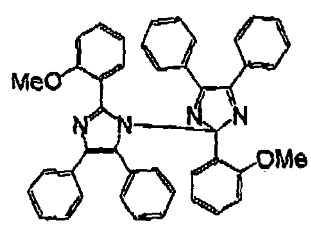

T-1

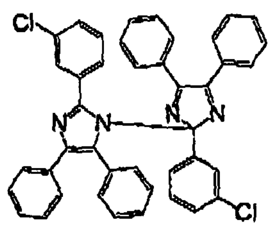

T-2

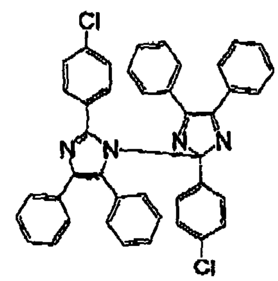

T-3

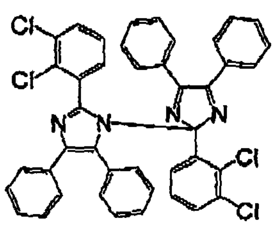

T-4

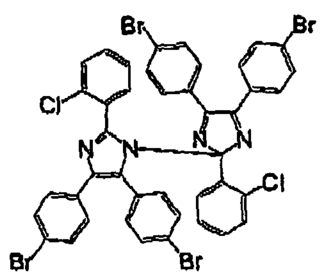

T-5

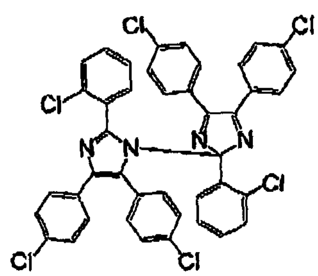

T-6

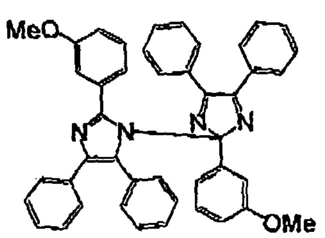

T-7

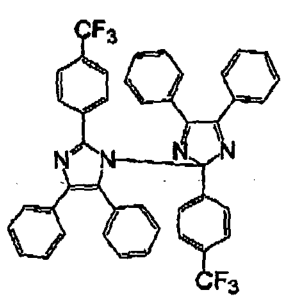

T-8

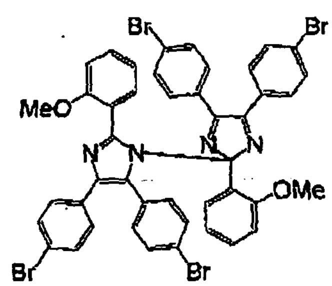

T-9

A representative synthesis example of the hexaarylbiimidazole compound is described below.

Synthesis of Compound T-1

<Operation process>

(The compound shown below is referred to as T'-1)

A mixture of 3.7 g of potassium ferricyanide, 3.1 g of potassium hydroxide, 70 ml of water and 40 ml of toluene was stirred at room temperature until the solid disappeared. Then, was added thereto 1.9 g of T' -1 and the mixture was heated by an oil bath at 80˚C, followed by stirred for 4 hours with refluxing.
The reaction solution after stirring for 4 hours with refluxing was allowed to cool, added thereto 100 ml of water and the mixture was extracted with toluene. The organic phase of toluene was washed with an aqueous sodium chloride solution and then with water. After the washing, the organic phase was concentrated to obtain a red-orange colored oily product. The oily product obtained was recrystallized with methanol to obtain 1.5 g the desired Compound T-1.

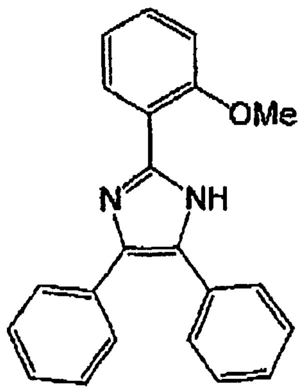

Other hexaarylbiimidazole compounds can also be synthesized in the same manner as above by appropriately selecting starting materials, compounds added and the like.
The hexaarylbiimidazole compound (imidazole compound A or B) is preferably incorporated in an amount form 0.5 to 20% by weight, more preferably from 1 to 10% by weight, based on the total solid content constituting the photosensitive composition according to the invention.
In the invention, other known photopolymerization initiator, thermal polymerization initiator and the like may be selected to use together with the specific hexaarylbiimidazole compound described above as long as the effects of the invention are not damaged. Examples of the polymerization initiator used together include known onium salts having no carboxylic acid structure in their counter cation portions, triazine compounds having a trihalomethyl group, peroxides, azo-based polymerization initiators, azido compounds and quininediazido compounds.
Specific examples of the onium salt preferably used as the polymerization initiator together with the specific hexaarylbiimidazole compound include compounds described in JP-A-2001-133969, paragraphs from [0030] to [0033].
When other polymerization initiator is used together with the specific hexaarylbiimidazole compound, an amount of the other polymerization initiator is preferably 50 parts by weight or less based on 100 parts by weight of the imidazole compound A or B as the specific polymerization initiator.
The polymerization initiator (imidazole compounds A and B and other polymerization initiator) for use in the invention preferably has an absorption maximum wavelength at 500 nm or shorter, more preferably 400 nm or shorter.

< (B) Sensitizing dye>

The sensitizing dye for use in the photosensitive composition according to the invention is preferably a sensitizing dye having an absorption peak in a wavelength range of 350 to 850 nm. When the absorption peak is shorter than 350 nm, the sufficient sensitizing effect can not be obtained since the absorption peak is shorter in view of the wavelength of laser currently utilized in the plate-making. A wavelength range exceeding 8OO nm also has the same problem. Therefore, from the standpoint of practical use, a sensitizing dye having an absorption peak in a wavelength range of 350 to 850 nm is selected.
Examples of the sensitizing dye include spectral sensitizing dyes, and dyes or pigments which absorb light of

a light source to interact with the photopolymerization initiator described below.

Preferred examples of the spectral sensitizing dye and dye include polynuclear aromatic compounds (e.g., pyrene, perylene or triphenylene), xanthenes (e.g., fluorescein, Eosine, Erythrosine, Rhodamine B or Rose Bengale), cyanines (e.g., thiacarbocyanine or oxacarbocyanine), merocyanines (e.g., merocyanine or carbomerocyanine), thiazines (e.g., Thionine, Methylene Blue or Toluidine Blue), acridines (e.g., Acridine Orange, chloroflavine or acriflavine), phthalocyanines (e.g., phthalocyanine or metal phthalocyanine), porphyrins (e.g., tetraphenylporphyrin or center metal-substituted porphyrin), chlorophylls (e.g., chlorophyll, chlorophyllin or center metal-substituted chlorophyll), metal complexes, anthraquinones (e.g., anthraquinone) and squaliums (e.g., squalium),

More preferred examples of the spectral sensitizing dye and dye include styryl dyes as described in JP-B-37-13034, cationic dyes as described in JP-A-62-143044, quinoxalinium salts as described in JP-B-59-24147, new Methylene Blue compounds as described in JP-A-64-33104, anthraquinones as described in JP-A-64-56767, benzoxanthene dyes as described in JP-A-2-1714, acridines as described in JP-A-2-226148 and JP-A-2-226149, pyrylium salts as described in JP-B-40-28499, cyanines as described in JP-B-46-42363, benzofuran dyes as described in JP-A-2-63053, conjugated ketone dyes as described in JP-A-2-85858 and JP-A-2-216154, dyes as described in JP-A-57-10605, azocinnamylidene derivatives as described in JP-B-2-30321, cyanine dyes as described in JP-A-1-287105, xanthene dyes as described in JP-A-62-31844, JP-A-62-31848 and JP-A-62-143043, aminostyryl ketones as described in JP-B-59-28325, merocyanine dyes as described in JP-B-61-9621, dyes as described in JP-A-2-179643, merocyanine dyes as described in JP-A-2-244050, merocyanine dyes as described in JP-B-59-28326, merocyanine dyes as described in JP-A-59-89803, merocyanine dyes as described in JP-A-8-129257 and benzopyran dyes as described in JP-A-8-334897.

In addition, the infrared absorbing agents (including dyes and pigments) described below are particularly preferably used as the sensitizing dyes. Preferred examples of the infrared absorbing dye include cyanine dyes as described, for example, in JP-A-58-125246, JP-A-59-84356, JP-A-59-202829 and JP-A-60-78787 and cyanine dyes as described in British Patent 434,875.

Other preferred examples of the infrared absorbing dye include near infrared absorbing sensitizers as described in U.S. Patent 5,156,938, substituted arylbenzo(thio)pyrylium salts as described in U.S. Patent 3,881,924, trimethinethiapyrylium salts as described in JP-A-57-142645 (U.S. Patent 4,327,169), pyrylium compounds as described in JP-A-58-181051, JP-A-58-220143, JP-A-59-41363, JP-A-59-84248, JP-A-59-84249, JP-A-59-146063 and JP-A-59-146061, cyanine dyes as described in JP-A-59-216146, pentamethinethiopyrylium salts as described in U.S. Patent 4,283,475, and pyrylium compounds as described in JP-B-5-13514 and JP-B-5-19702.

Other preferred examples of the infrared absorbing dye include near infrared absorbing dyes represented by formulae (I) and (II) of U.S. Patent 4,756,993, and phthalocyanine dyes as described in European Patent 916,513.

Anionic infrared absorbing agents as described in Japanese Patent Application No. 10-79912 (JP-A-11-338131) are also preferably used.

The anionic infrared absorbing agent means a dye that does not have a cation structure in the dye skeleton substantially absorbing an infrared ray and has an anion structure. The anionic infrared absorbing agent includes, for example, (b1) an anionic metal complex, (b2) an anionic carbon black, (b3) an anionic phthalocyanine, and (b4) a compound represented by formula (A) shown below. A counter cation of the anionic infrared absorbing agent is a monovalent or polyvalent cation containing a proton.

$$[G_a^- - M - G_b]_m X^{m+} \qquad (A)$$

The anionic metal complex (b1) is a complex in which the center metal and ligand thereof substantially absorbing light form an anion, as a whole.

The anionic carbon black (b2) includes carbon black having bonded thereto an anion group, for example, sulfonic acid, carboxylic acid or phosphonic acid, as a substituent. In order to introduce the anion group into carbon black, for example, a method of oxidizing carbon black with the desired acid as described in Carbon Black Kyokai ed., Carbon Black Binran, Third Edition, page 12, Carbon Black Kyokai (April 5, 1995) can be employed.

The anionic phthalocyanine (b3) is a compound in which the anion group as described with respect to the anionic carbon black (b2) is bonded to a phthalocyanine skeleton as a substituent to form an anion, as a whole.

The compound (b4) represented by formula (A) will be described in detail below.

In formula (A) above, $G_a^-$ represents an anionic substituent, $G_b$ represents a neutral substituent, $X^{m+}$ represents an m-valent cation containing a proton, m represents an integer of 1 to 6; and M represents a conjugate chain. The conjugate chain M may contain a substituent and/or a cyclic structure. The conjugate chain M is represented by the following formula:

$$-(C(-R^1) = C(-R^2))_n - C(-R^3) =$$

wherein $R^1$, $R^2$ and $R^3$ each independently represents a hydrogen atom, a halogen atom, a cyano group, an alkyl group, an aryl group, an alkenyl group, an alkynyl group, a carbonyl group, a thio group, a sulfonyl group, a sulfinyl group, an oxy group or an amino group, or $R^1$, $R^2$ and $R^3$ may be combined with each other to form a cyclic structure, and n represents an integer of 1 to 8.

Cationic infrared absorbing agents and nonionic infrared absorbing agents are also preferably used.

As other dyes, commercially available dyes and known dyes described, in literatures, for example, Senryo Binran (Dye Handbook) compiled by The Society of Synthetic Organic Chemistry, Japan (1970) can be utilized. Specifically, the dyes includes azo dyes, metal complex azo dyes, pyrazolone azo dyes, naphthoquinone dyes, anthraquinone dyes, phthalocyanine dyes, carbonium dyes, quinoneimine dyes, methine dyes, diimmonium dyes, aminium dyes, squarylium dyes and metal thiolate complexes.

Examples of the pigment used as the sensitizing dye include commercially available pigments and pigments described in Colour Index (C.I.), Saishin Ganryo Binran (Handbook of Newest Pigments) compiled by Pigment Technology Society of Japan (1977), Saishin Ganryo Oyou Gijutsu (Newest Application Technologies of Pigments), CMC Publishing Co., Ltd. (1986) and Insatsu Ink Gijutsu (Printing Ink Technology), CMC Publishing Co., Ltd. (1984). Examples of the pigment include black pigments, yellow pigments, orange pigments, brown pigments, red pigments, purple pigments, blue pigments, green pigments, fluorescent pigments, metal powder pigments and polymer-bonded dyes. Specific examples of the pigment used include insoluble azo pigments, azo lake pigments, condensed azo pigments, chelated azo pigments, phthalocyanine pigments, anthraquinone pigments, perylene and perynone pigments, thioindigo pigments, quinacridone pigments, dioxazine pigments, isoindolinone pigments, quinophthalone pigments, dying lake pigments, azine pigments, nitroso pigments, nitro pigments, natural pigments, fluorescent pigments, inorganic pigments and carbon black. Of the pigments, carbon black is preferred.

The pigment may be used without undergoing surface treatment or may be used after conducting the surface treatment. For the surface treatment, there are a method of coating a resin or wax on the pigment surface, a method of attaching a surfactant to the pigment surface and a method of bonding a reactive substance (for example, a silane coupling agent, an epoxy compound or a polyisocyanate) to the pigment surface. The surface treatment methods are described in Kinzoku Sekken no Seishitsu to Oyo (Properties and Applications of Metal Soap), Saiwai Shobo, Insatsu Ink Gijutsu (Printing Ink Technology), CMC Publishing Co., Ltd. (1984), and Saishin Ganryo Oyo Gijutsu (Newest Application Technologies of Pigments), CMC Publishing Co., Ltd. (1986).

A particle size of the pigment is preferably from 0.01 to 10 $\mu$m, more preferably from 0.05 to 1 $\mu$m, and particularly preferably from 0.1 to 1 $\mu$m.

As a method for dispersing the pigment, a known dispersion technique for use in the production of ink or toner can be used. Examples of the dispersing machine include an ultrasonic dispersing machine, a sand mill, an attritor, a pearl mill, a super-mill, a ball mill, an impeller, a disperser, a KD mill, a colloid mill, a dynatron, a three roll mill and a pressure kneader. The dispersing methods are described in detail in Saishin Ganryo Oyo Gijutsu (Newest Application Technologies of Pigments), CMC Publishing Co., Ltd. (1986).

More preferable examples of the sensitizing dye for use in the invention include the above described merocyanine dyes as described in JP-B-61-9621, merocyanine dyes as described in JP-A-2-179643, merocyanine dyes as described in JP-A-2-244050, merocyanine dyes as described in JP-B-59-28326, merocyanine dyes as described in JP-A-59-89803, merocyanine dyes as described in Japanese Patent Application No. 6-269047 (JP-A-8-129257) and benzopyran dyes as described in JP-A-8-334897, and the above-described infrared absorbing agents as described in JP-A-2001-33952.

The sensitizing dyes may be preferably used individually or in combination of two or more thereof in the invention. To the photosensitive composition of the invention may be further added a known compound having a function of further increasing sensitivity, a function of preventing polymerization inhibition due to oxygen or the like, as a co-sensitizer.

Details of the method of using the sensitizing dye, for example, selection of the structure, individual or combination use or an amount added, can be appropriately arranged depending on the characteristic design of the final photosensitive material.

For example, when two or more sensitizing dyes are used in combination, the compatibility with the photosensitive composition can be increased. For the selection of sensitizing dye, the molar absorption coefficient thereof at the emission wavelength of the light source used is an important factor in addition to the photosensitivity. Use of a dye having a large molar absorption coefficient is profitable, because the amount of dye added can be made relatively small. Also, in the case of preparing a lithographic printing plate precursor, the use of such a dye is advantageous in view of a physical property of the photosensitive layer. Since the photosensitivity and resolution of the photosensitive layer and the physical property of the exposed layer are greatly affected by the absorbance at the wavelength of light source, the amount of the sensitizing dye added is appropriately selected by taking account of these factors.

However, for the purpose of hardening a coating having a large thickness of 5 $\mu$m or more, low absorbance is sometimes rather effective in increasing the hardening degree.

In the case of using the sensitizing dye in a lithographic printing plate precursor where a photosensitive layer

has a relatively small thickness, the amount of the sensitizing dye added is preferably selected such that the photosensitive layer has an absorbance of 0.1 to 1.5, preferably from 0.25 to 1. For instance, in the case of using the sensitizing dye in a lithographic printing plate precursor, the amount of the sensitizing dye added is preferably from 0.05 to 30 parts by weight, more preferably from 0.1 to 20 parts by weight, and still more preferably from 0.2 to 10 parts by weight, per 100 parts by weight of the photosensitive composition.

The sensitizing dye for use in the invention may be subjected to various chemical modifications so that when it is used in a lithographic printing plate precursor, the characteristics of the photosensitive layer can be improved. For instance, the sensitizing dye may be bound to an addition-polymerizable compound structure (for example, an acryloyl group or a methacryloyl group) by a covalent bond, an ionic bond, a hydrogen bond or the like, whereby strength of the exposed layer can be increased and undesirable deposition of the dye in the layer after exposure can be inhibited.

Also, in the case of using the photosensitive composition according to the invention for the preparation of a lithographic printing plate precursor, introduction of a hydrophilic site (an acidic group or a polar group, for example, a carboxyl group or an ester thereof, a sulfonic acid group or an ester thereof, or an ethylene oxide group) to the dye is effective for the purpose of enhancing the processing aptitude with an (alkali) aqueous developer, which is a preferred use embodiment of the photosensitive layer. Particularly, the ester-type hydrophilic group has a feature in that it exhibits excellent compatibility in the photosensitive layer due to the relatively hydrophobic structure and in the developer, it is hydrolyzed to generate an acid group, thereby increasing hydrophilicity. In addition, a substituent can be appropriately introduced, for example, for the purpose of improving the compatibility or inhibiting the deposition of crystal in the photosensitive layer. For example, in a certain kind of photosensitive system, an unsaturated bond of an aryl group, an allyl group or the like is sometimes very effective for improving the compatibility. Moreover, the formation of a steric hindrance between n planes of the dyes by a method of introduction of a branched alkyl structure or the like can significantly inhibit the deposition of crystal. Also, adhesion to an inorganic material, for example, metal or metal oxide can be improved by the introduction of a phosphonic acid group, an epoxy group, a trialkoxysilyl group or the like. If desired, polymerization of the sensitizing dye may also be utilized.

<(C) Addition-polymerizable compound capable of reacting by at least one of radical and acid>

The photosensitive composition of the invention contains a compound which reacts by at least one of a radical and an acid to change its chemical or physical characteristic and to maintain in addition to the above-described photopolymerization initiation system. The compound specifically includes an addition-polymerizable compound having at least one ethylenically unsaturated double bond and it is selected from compounds having at least one, preferably two or more, terminal ethylenically unsaturated double bonds. Such compounds are broadly known in the field of art and they can be used in the invention without any particular limitation.

The compound has a chemical form, for example, a monomer, a prepolymer, specifically, a dimer, a trimer or an oligomer, or a copolymer thereof, or a mixture thereof. Examples of the monomer and copolymer thereof include unsaturated carboxylic acids (for example, acrylic acid, methacrylic acid, itaconic acid, crotonic acid, isocrotonic acid or maleic acid) and esters or amides thereof. Preferably, esters of an unsaturated carboxylic acid with an aliphatic polyhydric alcohol compound and amides of an unsaturated carboxylic acid with an aliphatic polyvalent amine compound are used.

An addition reaction product of an unsaturated carboxylic acid ester or amide having a nucleophilic substituent, for example, a hydroxy group, an amino group or a mercapto group, with a monofunctional or polyfunctional isocyanate or epoxy, or a dehydration condensation reaction product of the unsaturated carboxylic acid ester or amide with a monofunctional or polyfunctional carboxylic acid is also preferably used.

Moreover, an addition reaction product of an unsaturated carboxylic acid ester or amide having an electrophilic substituent, for example, an isocyanato group or an epoxy group with a monofunctional or polyfunctional alcohol, amine or thiol, or a substitution reaction product of an unsaturated carboxylic acid ester or amide having a releasable substituent, for example, a halogen group or a tosyloxy group with a monofunctional or polyfunctional alcohol, amine or thiol is also preferably used.

In addition, compounds in which the unsaturated carboxylic acid described above is replaced by an unsaturated phosphonic acid, styrene, vinyl ether or the like can also be used.

Specific examples of the monomer, which is an ester of an aliphatic polyhydric alcohol compound with an unsaturated carboxylic acid, include acrylic acid esters, for example, ethylene glycol diacrylate, triethylene glycol diacrylate, 1,3-butanediol diacrylate, tetramethylene glycol diacrylate, propylene glycol diacrylate, neopentyl glycol diacrylate, trimethylolpropane triacrylate, trimethylolpropane tri(acryloyloxypropyl) ether, trimethylolethane triacrylate, hexanediol diacrylate, 1,4-cyclohexanediol diacrylate, tetraethylene glycol diacrylate, pentaerythritol diacrylate, pentaerythritol triacrylate, pentaerythritol tetraacrylate, dipentaerythritol diacrylate, dipentaerythritol hexaacrylate, sorbitol triacrylate, sorbitol tetraacrylate, sorbitol pentaacrylate, sorbitol hexaacrylate, tri (acryloyloxyethyl) isocyanurate or polyester acrylate oligomer; methacrylic acid esters, for example, tetramethylene glycol dimethacrylate, triethylene glycol dimethacrylate, neopentyl glycol dimethacrylate, trimethylolpropane trimethacrylate, trimethylolethane trimethacrylate, ethylene glycol

dimethacrylate, 1,3-butanediol dimethacrylate, hexanediol dimethacrylate, pentaerythritol dimethacrylate, pentaerythritol trimethacrylate, pentaerythritol tetramethacrylate, dipentaerythritol dimethacrylate, dipentaerythritol hexamethacrylate, sorbitol trimethacrylate, sorbitol tetramethacrylate, bis[p-(3-methacryloxy-2-hydroxypropoxy)phenyl]dimethylmethane or bis[p-(methacryloxyethoxy)phenyl]dimethylmethane; itaconic acid esters, for example, ethylene glycol diitaconate, propylene glycol diitaconate, 1,3-butanediol diitaconate, 1,4-butanediol diitaconate, tetramethylene glycol diitaconate, pentaerythritol diitaconate or sorbitol tetraitaconate; crotonic acid esters, for example, ethylene glycol dicrotonate, tetramethylene glycol dicrotonate, pentaerythritol dicrotonate or sorbitol tetradicrotonate; isocrotonic acid esters, for example, ethylene glycol diisocrotonate, pentaerythritol diisocrotonate or sorbitol tetraisocrotonate; and maleic acid esters, for example, ethylene glycol dimaleate, triethylene glycol dimaleate, pentaerythritol dimaleate and sorbitol tetramaleate.

Other examples of the ester, which can be preferably used, include aliphatic alcohol esters described in JP-B-46-27926, JP-B-51-47334 and JP-A-57-196231, esters having an aromatic skeleton described in JP-A-59-5240, JP-A-59-5241 and JP-A-2-226149, and esters containing an amino group described in JP-A-1-165613.

The above-described ester monomers can also be used as a mixture.

Specific examples of the monomer, which is an amide of an aliphatic polyvalent amine compound with an unsaturated carboxylic acid, include methylene bisacrylamide, methylene bismethacrylamide, 1,6-hexamethylene bisacrylamide, 1,6-hexamethylene bismethacrylamide, diethylenetriamine trisacrylamide, xylylene bisacrylamide and xylylene bismethacrylamide.

Other preferred examples of the amide monomer include amides having a cyclohexylene structure described in JP-B-54-21726.

Urethane type addition-polymerizable compounds produced using an addition reaction between an isocyanate and a hydroxy group are also preferably used, and specific examples thereof include vinylurethane compounds having two or more polymerizable vinyl groups per molecule obtained by adding a vinyl monomer containing a hydroxy group represented by formula (VIII) shown below to a polyisocyanate compound having two or more isocyanate groups per molecule, described in JP-B-48-41708.

$$CH_2{=}C\ (R)\ COOCH_2CH\ (R')OH \qquad (VIII)$$

wherein R and R' each independently represents H or $CH_3$.

Also, urethane acrylates described in JP-A-51-37193, JP-B-2-32293 and JP-B-2-16765, and urethane compounds having an ethylene oxide skeleton described in JP-B-58-49860, JP-B-56-17654, JP-B-62-39417 and JP-B-62-39418 are preferably used.

Furthermore, a photopolymerizable composition having remarkably excellent photosensitive speed can be obtained by using an addition polymerizable compound having an amino structure or a sulfide structure in its molecule, described in JP-A-63-277653, JP-A-63-260909 and JP-A-1-105238.

Other examples include polyfunctional acrylates and methacrylates, for example, polyester acrylates and epoxy acrylates obtained by reacting an epoxy resin with (meth) acrylic acid, described in JP-A-48-64183, JP-B-49-43191 and JP-B-52-30490. Specific unsaturated compounds described in JP-B-46-43946, JP-B-1-40337 and JP-B-1-40336, and vinylphosphonic acid type compounds described in JP-A-2-25493 can also be exemplified. In some cases, structure containing a perfluoroalkyl group described in JP-A-61-22048 can be preferably used. Moreover, photocurable monomers or oligomers described in Nippon Secchaku Kyokaishi (Journal of Japan Adhesion Society), Vol. 20, No. 7, pages 300 to 308 (1984) can also be used.

Details of the method of using the addition-polymerizable compound, for example, selection of the structure, individual or combination use or an amount added, can be appropriately arranged depending on the characteristic design of the final photosensitive material. For instance, the compound is selected from the following standpoints. In view of the photo-speed, a structure having a large content of unsaturated groups per molecule is preferred and in many cases, a difunctional or more functional compound is preferred. Also, in the case of using the polymerizable compound in the photosensitive layer of a lithographic printing plate precursor, in order to increase the strength of image area, that is, hardened layer, a trifunctional or more functional compound is preferred. A combination use of compounds different in the functional number or in the kind of polymerizable group (for example, an acrylic acid ester, a methacrylic acid ester, a styrene compound or a vinyl ether compound) is an effective method for controlling both the sensitivity and the strength. The polymerizable compound having a large molecular weight or the polymerizable compound of high hydrophobicity is excellent in the layer strength but it may not be preferable in some cases from the standpoint of the development speed or deposition in a developer. The selection and method of using the addition-polymerizable compound are also important factors for the compatibility and dispersibility with other components (for example, a binder polymer described hereinafter, a photopolymerization initiator (system) described above or a coloring agent described hereinafter) in the photosensitive layer. For instance, the compatibility may be improved in some cases by using the compound of low purity or using two or more kinds of the compounds in combination. A specific structure may be selected for the purpose of improving an adhesion property to a support or a protective layer described hereinafter.

With respect to a ratio of the addition-polymerizable compound used in the photosensitive layer, a larger ratio is advantageous in view of the sensitivity but when the ratio is too large, undesirable phase separation may occur, a problemmay arise in the production step due to tackiness of the photosensitive layer (for example, production failure due to transfer or adhesion of the components of photosensitive material), and a problem of the deposition in the developer may occur. In view of these points, the ratio of the addition-polymerizable compound is in many cases preferably from 5 to 80% by weight, more preferably from 75% by weight, based on the total components of the composition. The addition-polymerizable compounds may be used individually or in combination of two or more thereof. In the method of using the addition-polymerizable compound, the structure, blend and amount added can be appropriately selected by taking account of the degree of polymerization inhibition due to oxygen, resolution, fogging property, change in refractive index, surface tackiness and the like. Further, depending on the case, a layer construction, for example, an undercoat layer or an overcoat layer, and a coating method, may also be considered.

<(D) Binder polymer>

In the application of the photosensitive composition according to the invention to a photosensitive layer of a lithographic printing plate precursor as a preferred embodiment of the invention, it is preferred to use a binder polymer in addition to the above-described photopolymerization initiation system and addition-polymerizable compound in the photosensitive layer. The binder is preferably a linear organic high molecular polymer. The "linear organic high molecular polymer" may be any linear organic high molecular polymer. Preferably, a linear organic high molecular polymer soluble or swellable in water or alkalescent water, which enables water development or alkalescent water development, is selected.

The linear organic high molecular polymer is selected not only as a film forming agent of the composition but also in consideration of the use of water, alkalescent water or organic solvent as a developer. For instance, when a water-soluble organic high molecular polymer is used, water development can be performed. Examples of the linear organic high molecular polymer include addition polymers having a carboxylic acid group in the side chain htereof, for example, methacrylic acid copolymers, acrylic acid copolymers, itaconic acid copolymers, crotonic acid copolymers, maleic acid copolymers and partially esterified maleic acid copolymers described in JP-A-59-44615, JP-B-54-34327, JP-B-58-12577, JP-B-54-25957, JP-A-54-92723, JP-A-59-53836 and JP-A-59-71048. Further, acidic cellulose derivatives having a carboxylic acid group in the side chain thereof may also be used. In addition, polymers obtained by adding a cyclic acid anhydride to addition polymers having a hydroxy group are also useful.

Among them, [benzyl (meth)acrylate/(meth)acrylic acid/other addition-polymerizable vinyl monomer, if desired] copolymers and [allyl (meth)acrylate/(meth)acrylic acid/other addition-polymerizable vinyl monomer, if desired] copolymers are preferred because of their excellent balance in the film strength, sensitivity and developing property.

Also, acid group-containing urethane binder polymers described in JP-B-7-120040, JP-B-7-120041, JP-B-7-120042, JP-B-8-12424, JP-A-63-287944, JP-A-63-287947, JP-A-1-271741 and JP-A-13-312062 are advantageous in view of printing durability and low exposure aptitude because of their very excellent strength. Moreover, a binder having an amido group described in JP-A-11-171909 is preferable because of both of the excellent developing property and the layer strength.

Furthermore, polyvinyl pyrrolidone, polyethylene oxide and the like are useful as the water-soluble linear organic polymer, Also, an alcohol-soluble nylon and a polyether of 2,2-bis-(4-hydroxyphenyl)propane with epichlorohydrin are useful for the purpose of increasing the strength of hardened layer. The linear organic high molecular polymer can be mixed in an appropriate amount to the photosensitive composition. However, when the amount exceeds 90% by weight, the preferable results are not obtained in view of the strength of image formed or the like. The amount added is preferably from 30 to 85% by weight. Also, the addition-photopolymerizable compound and the linear organic high molecular polymer are preferably used in a weight ratio of 1/9 to 7/3. According to a preferred embodiment, the linear organic high molecular polymer as the binder polymer is substantially insoluble in water and soluble in alkali. By using such a binder polymer, an organic solvent which is not preferable in view of the environmental concern can be avoided or limited to a very small amount. In such a case, an acid value (acid content per g of polymer, expressed by the chemical equivalent number) and molecular weight of the binder polymer are appropriately selected by taking account of the image strength and the developing property. The acid value is preferably in a range from 0.4 to 3.0 meq/g, more preferably from 0.6 to 2.0 meq/g, and the molecular weight is preferably in a range from 3,000 to 500,000, more preferably from 10,000 to 300,000.

<(E) Other components>

In the case of using the photosensitive composition according to the invention as the photosensitive layer of an image-recording material, for example, a lithographic printing plate precursor, other components suitable for the use, production method and the like are appropriately added to photosensitive composition. Preferred additives are described

below.

(E1) Co-sensitizer

The sensitivity of the photosensitive layer can be further elevated by using a certain additive (hereinafter referred to as a "co-sensitizer"). The operation mechanism of the co-sensitizer is not quite clear but may be considered to be mostly based on the following chemical process. Specifically, the co-sensitizer reacts with various intermediate active species (for example, a radical, a peroxide, an oxidizing agent or a reducing agent) generated during the process of photo-reaction initiated upon light absorption of the above-described photopolymerization initiation system and subsequent addition-polymerization reaction to produce new active radicals. Such compounds are roughly classified into (a) compound which is reduced to produce an active radical, (b) compound which is oxidized to produce an active radical and (c) compound which reacts with a radical having low activity to convert it into a more highly active radical or acts as a chain transfer agent. However, in many cases, a common view is not present about which compound belongs to which type.

(a) Compound which is reduced to produce an active radical Compound having carbon-halogen bond:

An active radical is considered to be generated by the reductive cleavage of carbon-halogen bond. Specific examples of the compound preferably used include a trihalomethyl-s-triazine and a trihalomethyloxadiazole.

Compound having nitrogen-nitrogen bond:

An active radical is considered to be generated by the reductive cleavage of nitrogen-nitrogen bond. Specific examples of the compound preferably used include a hexaarylbiimidazole.

Compound having oxygen-oxygen bond:

An active radical is considered to be generated by the reductive cleavage of oxygen-oxygen bond. Specific examples of the compound preferably used include an organic peroxide.

Onium compound:

An active radical is considered to be generated by the reductive cleavage of carbon-hetero bond or oxygen-nitrogen bond. Specific examples of the compound preferably used include a diaryliodonium salt, a triarylsulfonium salt and an N-alkoxypyridinium (azinium) salt.

Ferrocene and iron allene complexe:

An active radical may be reductively produced.

(b) Compound which is oxidized to produce an active radical Alkylate complex:

An active radical is considered to be generated by the oxidative cleavage of carbon-hetero bond. Specific examples of the compound preferably used include a triaryl alkyl borate.

Alkylamine compound:

An active radical is considered to be generated by the oxidative cleavage of C-X bond on the carbon adjacent to nitrogen, wherein X is preferably a hydrogen atom, a carboxy group, a trimethylsilyl group or a benzyl group. Specific examples of the compound include an ethanolamine, an N-phenylglycine and an N-trimethylsilylmethylaniline.

Sulfur-containing or tin-containing compound:

A compound in which the nitrogen atom of the above-described amine is replaced by a sulfur atom or a tin atom is considered to generate an active radical in the same manner. Also, a compound having an S-S bond is known to effect sensitization by the cleavage of S-S.

α-Substituted methylcarbonyl compound:

An active radical may be produced by the oxidative cleavage of carbonyl-α-carbon bond. The compound in which the carbonyl is converted into an oxime ether also shows the similar function. Specific examples of the compound include an 2-alkyl-1-[4-(alkylthio)phenyl]-2-morpholinopronone-1 and an oxime ether obtained by a reaction of the 2-alkyl-1-[4-(alkylthio)phenyl]-2-morpholinopronone-1 with a hydroxyamine and subsequent etherification of the N-OH.

Sulfinic acid salt:

An active radical may be reductively produced. Specific examples of the compound include sodium arylsulfinate.

(c) Compound which reacts with a radical to convert it into a more highly active radical or acts as a chain transfer agent:

For example, a compound having SH, PH, SiH or GeH in its molecule is used as the compound which reacts with a radical to convert it into a more highly active radical or acts as a chain transfer agent. The compound donates hydrogen to a low active radical species to produce a radical or is oxidized and deprotonized to produce a radical. Specific examples of the compound include a 2-mercaptobenzimidazole.

A large number of examples of the co-sensitizer are more specifically described, for example, in JP-A-9-236913 as additives for increasing sensitivity. Some of them are set forth below, but, the invention should not be construed as being limited thereto.

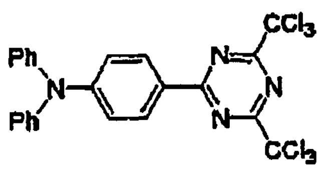
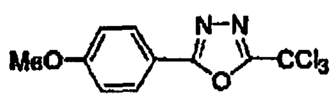
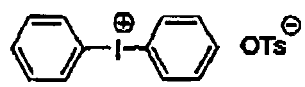

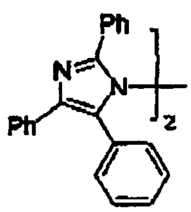
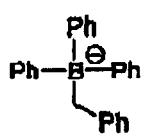
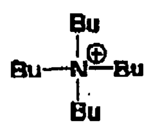
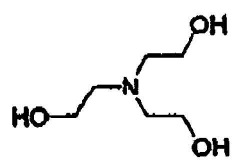

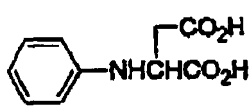
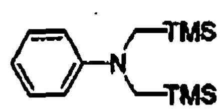
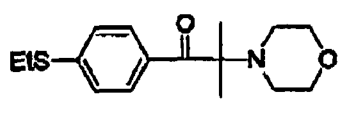

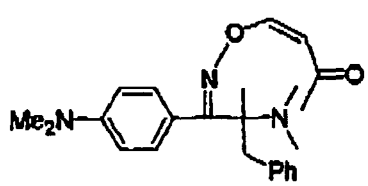
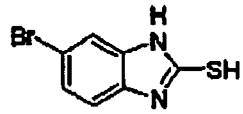

Similarly to the above-described sensitizing dye, the co-sensitizer can be subjected to various chemical modifications so as to improve the characteristics of the photosensitive layer of the lithographic printing plate precursor. For instance, methods, for example, binding to the sensitizing dye, photopolymerization initiator, addition-polymerizable unsaturated compound or other radical-generating part, introduction of a hydrophilic site, introduction of a substituent for improving compatibility or inhibiting deposition of crystal, introduction of a substituent for improving adhesion, and

formation of a polymer, may be used. The co-sensitizers may be used individually or in combination of two or more thereof. The amount of the co-sensitizer used is suitably from 0.05 to 100 parts by weight, preferably from 1 to 80 parts by weight, more preferably from 3 to 50 parts by weight, per 100 parts by weight of the addition-polymerizable compound having an ethylenically unsaturated double bond.

(F2) Thermal polymerization inhibitor

It is preferred to add a small amount of a thermal polymerization inhibitor to the photosensitive composition according to the invention in addition to the above-described basic components, in order to prevent undesirable thermal polymerization of the polymerizable compound having an ethylenically unsaturated double bond during the production or preservation of the photosensitive composition. Suitable examples of the thermal polymerization inhibitor include hydroquinone, p-methoxyphenol, di-tert-butyl-p-cresol, pyrogallol, tert-butylcatechol, benzoquinone, 4,4'-thiobis(3-methyl-6-tert-butylphenol), 2,2'-methylenebis(4-methyl-6-tert-butylphenol) and N-nitrosophenylhydroxyamine cerium (III) salt. The amount of the thermal polymerization inhibitor added is preferably from about 0.01 to about 5% by weight, based on the total components of the photosensitive composition. In the case of coating the photosensitive composition as the photosensitive layer of the lithographic printing plate precursor, in order to avoid polymerization inhibition due to oxygen, a higher fatty acid derivative, for example, behenic acid or behenic amide may be added and allowed to localize on the photosensitive layer surface during the drying step after the coating thereof, if desired. The amount of the higher fatty acid derivative added is preferably from about 0.5 to about 10% by weight based on the total components of the photosensitive composition.

(E3) Coloring agent

In the case of using the photosensitive composition according to the invention for the photosensitive layer of the lithographic printing plate precursor, a coloring agent of a dye or a pigment may further be added for the purpose of coloring the photosensitive layer. By the coloring, a so-called plate inspection property, for example, visibility of a printing plate after the plate-making or aptitude for an image density meter can be improved.

Since many dyes cause reduction in the sensitivity of photopolymerizable photosensitive layer, a pigment is preferably used as the coloring agent. Specific examples thereof include pigments, for example, a phthalocyanine pigment, an azo pigment, carbon black or titanium oxide, and dyes, for example, Ethyl violet, Crystal Violet, an azo dye, an anthraquinone dye or a cyanine dye. The amount of the dye or pigment added is preferably from about 0.5 to about 5% by weight based on the total components of photosensitive composition.

(E4) Other additives

In the case of using the photosensitive composition according to the invention for the photosensitive layer of the lithographic printing plate precursor, known additives, for example, an inorganic filler or a plasticizer for improving physical properties of the hardened layer, or an oil-sensitizer capable of improving the inking property on the surface of photosensitive layer may be further added.

Examples of the plasticizer include dioctyl phthalate, didodecyl phthalate, triethylene glycol dicaprylate, dimethyl glycol phthalate, tricresyl phosphate, dioctyl adipate, dibutyl sebacate and triacetyl glycerol. In the case of using a binder polymer, the plasticizer can be added in an amount of 10% by weight or less based on the total weight of the compound having an ethylenically unsaturated double bond and the binder polymer.

Also, an UV initiator, a heat crosslinking agent or the like may be added in order to increase the effect of heating or exposure after the development for the purpose of improving the layer strength (printing durability) of the photosensitive layer of the lithographic printing plate precursor which will be described hereinafter.

In addition, for improving the adhesion between the photosensitive layer and a support or increasing developing and removing property of the unexposed photosensitive layer, an additive may be added or an interlayer may be provided. For instance, a compound exhibiting a relatively strong interaction with the substrate described hereinafter, for example, a compound having a diazonium structure or a phosphone compound may be added or undercoated, whereby the adhesion is strengthened and the printing durability can be increased. Also, by the addition or undercoating of a hydrophilic polymer, for example, polyacrylic acid or polysulfonic acid, the developing property of the non-image area is improved and resistance to stain can be increased.

In the case of coating the photosensitive composition according to the invention on a support to provide the photosensitive layer of the lithographic printing plate precursor, the composition is used after dissolving it in various organic solvents. Examples of the solvent used include acetone, methyl ethyl ketone, cyclohexane, ethyl acetate, ethylene dichloride, tetrahydrofuran, toluene, ethylene glycol monomethyl ether, ethylene glycol monoethyl ether, ethylene glycol dimethyl ether, propylene glycol monomethyl ether, propylene glycol monoethyl ether, acetylacetone, cyclohexanone,

diacetone alcohol, ethylene glycol monomethyl ether acetate, ethylene glycol ethyl ether acetate, ethylene glycol monoisopropyl ether, ethylene glycol monobutyl ether acetate, 3-methoxypropanol, methoxymethoxyethanol, diethylene glycol monomethyl ether, diethylene glycol monoethyl ether, diethylene glycol dimethyl ether, diethylene glycol diethyl ether, propylene glycol monomethyl ether acetate, propylene glycol monoethyl ether acetate, 3-methoxypropyl acetate, N,N-dimethylformamide, dimethyl sulfoxide, y-butyrolaotone, methyl lactate and ethyl lactate. The solvents may be used individually or as a mixture of two or more thereof. The concentration of solid content in the coating solution is suitably from 2 to 50% by weight.

The image-recording material of the invention will be described below.

The image-recording material of the invention has a photosensitive layer comprising the above-described photosensitive composition according to the invention.

In the image-recording material of the invention, the photosensitive layer is provided on a support similar to conventional image-recording materials.

The coverage of the photosensitive layer on the support has the main influence on the sensitivity and developing property of the photosensitive layer, the strength of the exposed layer and the printing durability and therefore, an appropriate coverage is preferably selected according to the use end. When the coverage is too small, the printing durability is not sufficient, whereas when it is excessively large, the sensitivity decreases and as a result, not only the exposure but also the development processing disadvantageously take a longer time. In the case of a lithographic printing plate precursor for scanning exposure, which is one of the main intended uses of the photosensitive composition according to the invention, the coverage is preferably from about 0.1 to about 10 $g/m^2$, more preferably from 0.5 to 5 $g/m^2$, in terms of the weight after drying.

(Backcoat)

After performing the surface treatments on the support or forming the intermediate layer on the support, a backcoat may be provided on the rear surface of the support, if desired.

The backcoat preferably includes, for example, a coating layer comprising an organic polymer compound described in JP-A-5-45885 and a coating layer comprising a metal oxide obtained by hydrolysis and polycondensation of an organic metallic compound or inorganic metallic compound. Among them, an alkoxy compound of silicon, for example, $Si(OCH_3)_4$, $Si(OC_2H_5)_4$ $Si(OC_3H_7)_4$ or $Si(OC_4H_9)_4$ is preferably used, since the starting materials thereof are not expensive and easily available.

<(F) Support>

In order to obtain a lithographic printing plate precursor as one of the main intended uses of the photosensitive composition according to the invention, the photosensitive layer comprising the photosensitive composition is preferably provided on a support having a hydrophilic surface. As for the hydrophilic support, conventionally known hydrophilic supports used for lithographic printing plate precursors can be used without any limitation.

The support used is preferably a dimensionally stable plate-like material, for example, paper, paper laminated with plastic (e.g., polyethylene, polypropylene or polystyrene), a metal plate (e.g., an aluminum, zinc or copper plate), a plastic film (e.g., a cellulose diacetate, cellulose triacetate, cellulose propionate, cellulose butyrate, cellulose acetate butyrate, cellulose nitrate, polyethylene terephthalate, polyethylene, polystyrene, polypropylene, polycarbonate or polyvinyl acetal film) and paper or a plastic film having laminated or vapor-deposited thereon the above-described metal. If desired, the surface of the support may be appropriately subjected to a known physical or chemical treatment for the purpose of imparting hydrophilicity, improving the strength or the like.

As the preferred support, paper, a polyester film and an aluminum plate are exemplified. Among them, the aluminum plate is particularly preferable, because it has good dimensional stability, is relatively inexpensive and can provide a surface having excellent hydrophilicity and strength by a surface treatment, if desired. Also, the composite sheet comprising an aluminum sheet having bonded thereon a polyethylene terephthalate film described in JP-B-48-18327 is preferable.

The aluminum plate is preferably a pure aluminum plate or an alloy plate mainly comprising aluminum and containing a trace amount of hetero elements. A plastic film laminated or vapor-deposited with aluminum may also be used. Examples of the hetero element contained in the aluminum alloy include silicon, iron, manganese, copper, magnesium, chromium, zinc, bismuth, nickel and titanium. The content of the hetero element in the alloy is at most 10% by weight. The aluminum particularly preferred in the invention is pure aluminum, however, since perfectly pure aluminum is difficult to produce in view of the refining technique, the aluminum may contain a trace amount of hetero elements. The composition of the aluminum plate for use in the invention is not specified and conventionally known and used aluminum plates can be appropriately employed. The thickness of the aluminum plate for use in the invention is approximately from 0.1 to 0.6 mm, preferably from 0.15 to 0.4 mm, and particularly preferably from 0.2 to 0.3 mm.

In the case of a support having a metal surface, particularly an aluminum surface, the support is preferably subjected to a surface treatment, for example, surface roughening (graining) treatment, immersing treatment in an aqueous solution of sodium silicate, potassium fluorozirconate, a phosphate or the like, or anodizing treatment.

The surface roughening treatment of the aluminum plate may be performed by various methods, for example, a method of mechanically roughening the surface, a method of electrochemically dissolving and roughening the surface or a method of selectively dissolving the surface by chemical means. Examples of the mechanical method which can be used include known methods, for example, ball graining, brush graining, blast graining and buff graining. Examples of the electrochemical surface roughing method include a method of performing the surface roughening in an electrolytic solution, for example, hydrochloric acid or nitric acid by passing an alternating current or a direct current. A combination of these two kinds of methods described in JP-A-54-63902 may also be used. If desired, in order to remove rolling oil on the surface, a degreasing treatment with a surfactant, an organic solvent, an alkaline aqueous solution or the like is performed in advance of the surface roughening of the aluminum plate.

An aluminum plate subjected to the roughening treatment and then the immersing treatment in an aqueous sodium silicate solution may also be preferably used. An aluminum plate subjected to an anodizing treatment and then to the immersing treatment in an aqueous alkali metal silicate solution described in JP-B-47-5125 is preferably used. The anodizing treatment is performed by passing a current using the aluminum plate as an anode in an aqueous or non-aqueous electrolytic solution of an inorganic acid, for example, phosphoric acid, chromic acid, sulfuric acid or boric acid, an organic acid, for example, oxalic acid or sulfamic acid, or a salt thereof. The aqueous or non-aqueous electrolytic solutions may be used individually or in combination of two or more thereof.

The silicate electrodeposition described in U.S. Patent 3,658,662 is also effective.

Further, a surface treatment in which a support subjected to electrolytic graining is combined with the above-described anodizing treatment and sodium silicate treatment, described in JP-B-46-27481, JP-A-52-58602 and JP-A-52-30503 is also useful.

Also, a support subjected to mechanical roughening, chemical etching, electrolytic graining, anodizing and sodium silicate treatment in this order as described in JP-A-56-28893 is preferably used.

A support which is subjected to, after these treatments, undercoating with a water-soluble resin, for example, polyvinylphosphonic acid, a polymer or copolymer having a sulfonic acid group on the side chain, polyacrylic acid, a water-soluble metal salt (e.g., zinc borate), a yellow dye, an amine salt or the like, is also preferably used.

In addition, a substrate subjected to a sol-gel treatment, where a functional group capable of undergoing an addition reaction by a radical is covalently bonded, described in JP-A-7-159983 may also be preferably used.

Other preferred examples include a support provided with a water-resistant hydrophilic layer as a surface layer on an appropriate support. Examples of the surface layer include a layer comprising an inorganic pigment and a binder described in U.S. Patent 3,055,295 and JP-A-56-13168, a hydrophilic swellable layer described in JP-A-9-80744 and a sol-gel film comprising titanium oxide, polyvinyl alcohol and an silicic acid described in JP-W-8-507727 (the term "JP-W" as used herein means an "unexamined published Japanese international patent application").

The hydrophilization treatment is performed not only to render the support surface hydrophilic but also to prevent a detrimental reaction of the photosensitive composition provided thereon and to increase the adhesion of the photosensitive layer.

<(G) Protective layer>

In the case of a lithographic printing plate precursor for scanning exposure as a preferred use embodiment of the photosensitive composition according to the invention, the exposure is ordinarily performed in the atmosphere and therefore, it is preferred that a protective layer is further provided on the layer comprising the photosensitive composition.

The protective layer prevents a low molecular weight compound, for example, oxygen or a basic substance present in the atmosphere, which inhibits the image-forming reaction initiated upon exposure in the photosensitive layer, from permeating into the photosensitive layer, and enables exposure in the atmosphere. Accordingly, the characteristics required for the protective layer include to have a low permeability of the low molecular weight compound, for example, oxygen, not to substantially inhibit transmission of light used for the exposure, to exhibit good adhesion to the photosensitive layer and to be easily removed in a developing step after the exposure. Various investigations on the protective layer have been made and are described in detail, for example, in U.S. Patent 3,458,311 and JP-A-55-49729.

The material which can be used in the protective layer is preferably, for example, a water-soluble polymer compound having relatively excellent crystallinity. Specifically, a water-soluble polymer, for example, polyvinyl alcohol, polyvinyl pyrrolidone, acidic cellulose, gelatin, gum arabic and a polyacrylic acid are known. Among them, when polyvinyl alcohol is used as the main component, most excellent results can be obtained in view of fundamental characteristics, for example, an oxygen blocking property and a removability by development. The polyvinyl alcohol used for the protective layer may be partially substituted with an ester, an ether or an acetal as far as it contains the unsubstituted vinyl alcohol units sufficient for ensuring the necessary oxygen blocking property and water solubility. Similarly, a part of the polyvinyl

alcohol may have other copolymer component. Examples of the polyvinyl alcohol include those having a hydrolysis degree of 71 to 100% and a polymerization degree of 300 to 2,400.

Specific examples thereof include PVA-105, PVA-110, PVA-117, PVA-117H, PVA-120, PVA-124, PVA-124H, PVA-CS, PVA-CST, PVA-HC, PVA-203, PVA-204, PVA-205, PVA-210, PVA-217, PVA-220, PVA-224, PVA-217EE, PVA-217E, PVA-220E, PVA-224E, PVA-405, PVA-420, PVA-613 and L-8 produced by Kuraray Co., Ltd.

The components (selection of PVA, use of additives) and coating amount of the protective layer are determined by taking account of the oxygen blocking property, removability by development, fogging property, adhesion and scratch resistance. In general, as the hydrolysis degree of PVA used is higher (as the unsubstituted vinyl alcohol unit content in the protective layer is higher) and as the layer thickness is larger, the oxygen blocking property becomes higher, which is advantageous in view of the sensitivity. However, if the oxygen blocking property is excessively increased, there arise problems, for example, in that an undesirable polymerization reaction takes place during the production or preservation of the lithographic printing plate precursor, or in that undesirable fogging or thickening of image lines is caused at the time of image exposure. The adhesion to the photosensitive layer and scratch resistance are also important factors in view of handling of the lithographic printing plate precursor. More specifically, when a hydrophilic layer comprising a water-soluble polymer is laminated on a lipophilic polymerizable layer, peeling is liable to occur due to insufficient adhesion and the peeled part causes a defect, for example, hardening failure of the layer due to polymerization inhibition by oxygen.

To overcome such a problem, various proposals have been made with an attempt to improve the adhesion between these two layers. For instance, the sufficient adhesion can be obtained by mixing from 20 to 60% by weight of an acrylic emulsion, a water-insoluble vinyl pyrrolidone-vinyl acetate copolymer or the like in a hydrophilic polymer comprising a polyvinyl alcohol and laminating the mixture on the photosensitive layer. Every known technique can be applied to the protective layer according to the invention. A coating method of the protective layer is described in detail, for example, in U.S. Patent 3,458,311 and JP-A-55-49729.

Furthermore, other functions may also be imparted to the protective layer. For instance, when a coloring agent (for example, a water-soluble dye) having excellent transmittance of light of 350 to 450 nm for use in the exposure and capable of efficiently absorbing light of 500 nm or longer is added, a safe light aptitude can be more improved without causing reduction in the sensitivity.

Now, the image-recording method according to the invention is described below.

The image-recording method according to the invention preferably includes an image-recording method comprising conducting scanning exposure to the above-described image-recording material according to the invention having a photosensitive layer containing the photosensitive composition according to the invention using a laser light source having a wavelength of 450 nm or shorter.

In the image-recording method according to the invention, similar to conventional image-recording methods, after the image exposure, the unexposed area of the photosensitive layer is removed with a developer to form an image.

In the case where the photosensitive material using the photosensitive composition according to the invention is employed as an image-recording material, for example, a lithographic printing plate precursor, an image is ordinarily obtained by performing the image exposure and then removing the unexposed area of the photosensitive layer with a developer. Examples of the developer preferably employed in the case of using the photosensitive composition in a lithographic printing plate precursor include a developer described in JP-B-57-7427. The developer is suitably an aqueous solution of an inorganic alkali agent, for example, sodium silicate, potassium silicate, sodium hydroxide, potassium hydroxide, lithium hydroxide, sodium tertiary phosphate, sodium secondary phosphate, ammonium tertiary phosphate, ammonium secondary phosphate, sodium metasilicate, sodium bicarbonate or aqueous ammonia, or an aqueous solution of an organic alkali agent, for example, monoethanolamine or diethanolamine. The alkali agent is added so as to form an alkali solution having the concentration of 0.1 to 10% by weight, preferably from 0.5 to 5% by weight.

The aqueous alkaline solution may contain a small amount of a surfactant or an organic solvent, for example, benzyl alcohol, 2-phenoxyethanol and 2-butoxyethanol, if desired. Examples thereof include those described in U.S. Patents 3,375,171 and 3,615,480. Further, the developers described in JP-A-50-26601, JP-A-58-54341, JP-B-56-39464 and JP-B-56-42860 are also excellent.

As a particularly preferable developer, a developer containing a nonionic compound represented by formula shown below and having pH of 11.5 to 12.8 and conductivity of 3 to 30 mS/cm, described in JP-A-2002-202616 is exemplified.

A-W

(wherein A represents a hydrophobic organic group forming A - H having Log P of 1.5 or more, and W represents a nonionic hydrophilic organic group forming W - H having Log P of less than 1.0.)

Further, in the process of preparing a lithographic printing plate from the lithographic printing plate precursor using the photosensitive composition according to the invention in the photosensitive layer thereof, the entire surface

of the lithographic printing plate precursor may be heated, if desired, before or during the exposure or between the exposure and the development. By the heating, the image-forming reaction in the photosensitive layer is accelerated and advantages, for example, improvement in the sensitivity and printing durability and stabilization of the sensitivity are achieved. For the purpose of increasing the image strength and printing durability, it is also effective to perform entire after-heating or entire exposure of the image after the development. Ordinarily, the heating before the development is preferably performed under a mild condition of 150˚C or lower. When the temperature is too high, a problem may arise in that the non-image area is also fogged. The heating after the development uses a very strong condition, ordinarily in a range from 200 to 500˚C. When the temperature is too low, a sufficient effect of strengthening the image may not be obtained, whereas when it is excessively high, a problem of deterioration of the support and thermal decomposition of the image area may occur.

As for the exposure method of the lithographic printing plate precursor using the photosensitive composition according to the invention in the photosensitive layer thereof, known methods can be used without limitation. A wavelength of the light source used is preferably 450 nm or shorter, more preferably from 350 to 450 nm. Specifically, an InGaN semiconductor laser is preferably used. The exposure mechanism may be any of an internal drum system, an external drum system and a flat bed system. When the photosensitive composition of the invention used has high water solubility, the photosensitive layer can be made soluble in neutral water or alkalescent water and the lithographic printing plate precursor having such a construction can be loaded on a printing machine and then subjected to exposure and development on the machine.

Examples of other light source for use in the exposure of the photosensitive composition according to the invention include an ultra-high pressure mercury lamp, a high pressure mercury lamp, a medium pressure mercury lamp, a low pressure mercury lamp, a chemical lamp, a carbon arc lamp, a xenon lamp, a metal halide lamp, various visible or ultraviolet laser lamps, a fluorescent lamp, a tungsten lamp and sunlight.

As the available laser light source of 350 to 450 nm, the followings can be employed.

A gas laser, for example, Ar ion laser (364 nm, 351 nm, 10 mW to 1 W), Kr ion laser (356 nm, 351 nm, 10 mW to 1 W) and He-Cd laser (441 nm, 325 nm, 1 mW to 100 mW) may be used. A solid laser, for example, a combination of Nd:YAG ($YVO_4$) with SHG crystalsxtwice (355 nm, 5 mW to 1 W) and a combination of Cr:LiSAF with SHG crystal (430 nm, 10 mW) may be used.

A semiconductor laser system, for example, a $KNBOb_3$ ring resonator (430 nm, 30 mW), a combination of a waveguide-type wavelength conversion element with an AlGaAs or InGaAs semiconductor (380 nm to 450 nm, 5 mW-100 mW), a combination of a waveguide-type wavelength conversion element with an AlGaInP or AlGaAs semiconductor (300 nm to 350 nm, 5 mW to 100 mW), and AlGaInN (350 nm to 450 nm, 5 mW to 30 mW) may be used. A pulse laser, for example, $N_2$ laser (337 nm, pulse 0.1 to 10 mJ) and XeF (351 nm, pulse 10-250 mJ) may be used.

Among the light sources, the AlGaInN semiconductor laser (commercially available InGaN semiconductor laser, 400 to 410 nm, 5 to 30 mW) is particularly preferable in view of the wavelength characteristics and cost.

As for the exposure apparatus for a lithographic printing plate precursor of scanning exposure system, the exposure mechanism includes an internal drum system, an external drum system and a flat bed system. The light source preferably used is a light source capable of continuous oscillation among the above-described light sources. In practice, the following exposure apparatuses are particularly preferred in view of the relationship between the sensitivity of photosensitive material and the time for plate-making.

A single to triple beam exposure apparatus of internal drum system, using one or more gas or solid laser light source to give a semiconductor laser having a total output of 20 mW or more.

A multi-beam (from 1 to 10 beams) exposure apparatus of flat bed system, using one or more semiconductor, gas or solid laser to give a total output of 20 mW or more.

A multi-beam (from 1 to 9 beams) exposure apparatus of external drum system, using one or more semiconductor, gas or solid laser to give a total output of 20 mW or more.

A multi-beam (10 or more beams) exposure apparatus of external drum system, using one or more semiconductor or solid laser to give a total output of 20 mW or more.

In the laser direct drawing-type lithographic printing plate precursor, the following equation (eq 1) is ordinarily established among the sensitivity X ($J/cm^2$) of photosensitive material, the exposure area S ($cm^2$) of photosensitive material, the power q (W) of one laser light source, the number n of lasers and the total exposure time t (s):

$$X \cdot S = n \cdot q \cdot t \qquad \text{(eq 1)}$$

i) In the case of the internal drum (single beam) system

The following equation (eq 2) is ordinarily established among the laser revolution number f (radian/s), the sub-scanning length Lx (cm) of photosensitive material, the resolution Z (dot/cm) and the total exposure time t (s):

$$f \cdot Z \cdot t = Lx \qquad \text{(eq 2)}$$

ii) In the case of the external drum (multi-beam) system

The following equation (eq 3) is ordinarily established among the drum revolution number F (radian/s), the sub-scanning length Lx (cm) of photosensitive material, the resolution Z (dot/cm), the total exposure time t (s) and the number (n) of beams:

$$F \cdot Z \cdot n \cdot t = Lx \qquad \text{(eq 3)}$$

iii) In the case of the flat bed (multi-beam) system

The following equation (eq 4) is ordinarily established among the revolution number H (radian/s) of polygon mirror, the sub-scanning length Lx (cm) of photosensitive material, the resolution Z (dot/cm), the total exposure time t (s) and the number (n) of beams:

$$F \cdot Z \cdot n \cdot t = Lx \qquad \text{(eq 4)}$$

When the resolution (2,560 dpi) required for practical printing plate, the plate size (A1/B1, sub-scanning length: 42 inch), the exposure condition of about 20 sheets/1 hour and the photosensitive characteristics (photosensitive wavelength, sensitivity: about 0.1 mJ/$cm^2$) of the photosensitive composition of the invention are substituted for the above equations, it can be understood that a photosensitive material using the photosensitive composition of the invention is preferably combined with a multi-beam exposure system using a semiconductor laser to give a total output of 20 mW or more and on taking account of operability, cost and the like, most preferably combined with an external drum system semiconductor laser multi-beam (10 or more beams) exposure apparatus.

While the invention has been described in detail, the invention should not be construed as being limited to the description above and various changes and modifications can be made therein without departing from the spirit and scope thereof.

As to the use of the photosensitive composition according to the invention, it can be applied not only to the lithographic printing plate precursor for scanning exposure but also to the uses over a wide range known as those of photo-curable resin without limitation. For instance, when it is applied to a liquid photopolymerizable composition using a cationic polymerizable compound in combination, if desired, a highly sensitive material for photo-modeling can be obtained. A hologram material may also be prepared by utilizing change in the refraction index accompanied with the photopolymerization. The photosensitive composition of the invention can also be applied to various transfer materials (for example, a peelable photosensitive material or a toner development photosensitive material) by using change in the adhesive property on the surface accompanied with the photopolymerization, to photo-curing of microcapsules, to the production of an electronic material, for example, photoresist, and to a photocurable resin material, for example, ink, paint and adhesive.

The photopolymerization initiation system comprising imidazole compound A or B as a initiator and the sensitizing dye included in the photosensitive composition according to the invention is a photopolymerization initiation system excellent in both of the photosensitivity and the stability, and it can be applied to various uses other than the above-described photosensitive composition. For instance, generation of a radical with high efficiency upon light can cause an oxidative coloration of a triphenylmethane leuco dye at a high sensitivity. Also, it can cause a decoloring reaction of a certain polymethine dye due to addition of a radical. Further, since the photopolymerization initiation system generates an acid component together with the radical upon light, highly sensitive image-forming materials can be prepared by using it in combination with a compound which changes its absorption with an acid, a resin composition which causes a crosslinking reaction with an acid or a resin composition which is decomposed with an acid to increase its solubility.

EXAMPLES

The present invention will be described in more detail with reference to the following examples, but the invention should not be construed as being limited thereto.

EXAMPLES 1 TO 38 AND COMPARATIVE EXAMPLES 1 TO 24

(Preparation of support)

A 0.3 mm-thick aluminum plate was etched by immersing in a 10% by weight aqueous sodium hydroxide solution at 60˚C for 25 seconds, washed with running water, neutralized and cleaned with a 20% by weight aqueous nitric acid solution and then washed with water. The aluminum plate was then subjected to an electrolytic surface roughening treatment in a 1% by weight aqueous nitric acid solution using an alternating current with a sinusoidal waveform at an anode time electricity of 300 coulomb/$dm^2$. Subsequently, the aluminum plate was immersed in a 1% by weight aqueous sodium hydroxide solution at 40˚C for 5 seconds, immersed in a 30% by weight aqueous sulfuric acid solution at 60˚C for 40 seconds to effect a desmut treatment, and then subjected to an anodizing treatment in a 20% by weight aqueous sulfuric acid solution for 2 minutes at a current density of 2 A/$dm^2$ to form an anodic oxide film having a thickness of 2.7 g/$m^2$. The surface roughness of the aluminum plate was measured and found to be 0.3 μm (Ra value according to JIS B0601).

On the back surface of the thus-treated aluminum plate, the sol-gel reaction solution shown below was coated by a bar coater and dried at 100˚C for 1 minute, thereby preparing a support having provided thereon a backcoat layer having a coating amount after drying of 70 mg/$m^2$.

Sol-gel reaction solution

| | |
|---|---|
| Tetraethyl silicate | 55 parts by weight |
| Water | 25 parts by weight |
| Methanol | 10 parts by weight |
| Phosphoric acid | 0.05 parts by weight |

The above components were mixed and stirred, and heat generation was started within about 5 minutes. After reacting the mixture for 60 minutes, the ingredient solution shown below was added thereto to prepare the coating solution for backcoat layer.

Ingredient solution

| | |
|---|---|
| Pyrogallol formaldehyde condensed resin (molecular weight: 2,000) | 6 parts by weight |
| Dimethyl phthalate | 6 parts by weight |
| Fluorine-based surfactant (N-butylperfluorooctane sulfonamidoethyl acrylate/ polyoxyethylene acrylate copolymer, molecular weight: 20,000) | 0.7 parts by weight |
| Methanol silica sol (produced by Nissan chemical Industries, Ltd., methanol: 30% by weight) | 50 parts by weight |
| Methanol | 800 parts by weight |

(Preparation of photosensitive layer)

On the support of thus-treated aluminum plate provided with the backcoat layer, a photosensitive composition having the composition shown below was coated to have a dry coating amount of 1.0 g/$m^2$ and dried at 80˚C for 2 minutes to form a photosensitive layer.

Photosensitive composition

| | |
|---|---|
| Addition-polymerizable compound (Polymerizable compound shown below) | 1.5 g |
| Binder polymer (Allyl methacrylate/methacrylic acid/N-isopropylacrylamide copolymer (copolymerization molar ratio: 67/13/20)) | 2.0 g |
| Photopolymerization initiation system (shown in Tables 1 and 2) | |
| Sensitizing dye | X g |
| Initiator compound | Y g |
| Co-sensitizer Other component: | Z g |
| Fluorine-based nonionic surfactant (F-177P) | 0.02 g |
| Thermal polymerization inhibitor (N-nitrosophenylhydroxylamine aluminum salt) | 0.01 g |
| Pigment dispersion | 2.0 g |

(Composition of pigment dispersion)

| | |
|---|---|
| Pigment Blue 15:6 | 15 parts by weight |
| Allyl methacrylate/methacrylic acid copolymer (copolymeriza tion molar ratio: 83/17) | 10 parts by weight |
| Cyclohexanone | 15 parts by weight |
| Methoxypropyl acetate | 20 parts by weight |
| Propylene glycol monomethyl ether | 40 parts by weight |
| Solvent: | |
| Methyl ethyl ketone | 20.0 g |
| Propylene glycol monomethyl ether | 20.0 g |

Photopolymerizable compound

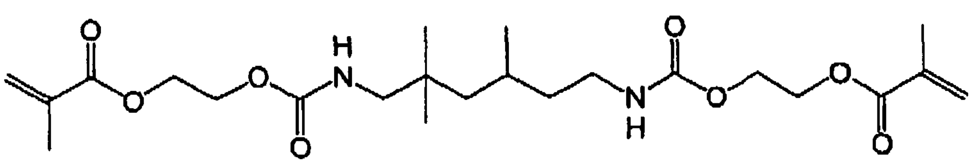

(Preparation of protective layer)

On the photosensitive layer, an aqueous solution containing 3% by weight of polyvinyl alcohol (saponification degree: 98% by mole; polymerization degree: 550) was coated to have a dry coating weight of 2 $g/m^2$ and dried at 100˚C for 2 minutes.

<Exposure wavelength-classified evaluation method of sensitivity>

(Evaluation of sensitivity 1: Exposure at 830 nm)

The negative-working lithographic printing plate precursor obtained was exposed by Trendsetter 3244VFS, produced by Creo Co. , equipped with a water-cooled 40 W infrared semiconductor laser under the conditions of power of 9 W, a rotational number of the outer surface drum of 210 rpm, energy on the plate surface of 100 $mJ/cm^2$ and resolution of 2,400 dpi.

After the exposure, the lithographic printing plate precursor was subjected to development processing using

an automatic developing machine (Stablon 900N, produced by Fuji Photo Film Co., Ltd.). A solution prepared by 1:4 dilution of DV-2, produced by Fuji Photo Film Co., Ltd. with water was used for the tank solution and replenisher of developer. The temperature of the developer was 30˚C. A solution prepared by 1:1 dilution of FN-6, produced by Fuji Photo Film Co. , Ltd. with water was used as the finisher.

On the basis of the line width of image obtained by the exposure (with an infrared laser having a wavelength approximately from 830 to 850 nm) and development, laser power, loss of the optical system and scanning speed, an energy amount necessary for recording was calculated. As the value is smaller, the sensitivity is higher. The results are also shown in Tables 1 and 2.

The exposure at 830 nm was conducted in Examples 1 to 6 and Comparative Examples 1 to 6.

(Evaluation of sensitivity 2: Exposure at 532 or 405 nm)

A Fuji Step Guide (a gray scale discontinuously changing in the transmission optical density at $\Delta D=0.15$, produced by Fuji Photo Film Co., Ltd.) was brought into close contact with the lithographic printing plate precursor obtained and exposure was performed using a xenon lamp through an optical filter (KENKO BP-53 (for 532 nm) or KENKO BP-40 (for 405 nm) in a known exposure energy amount. For the purpose of estimating the exposure aptitude for a short wavelength semiconductor laser, KENKO BP-53 capable of conducting exposure with monochromic light of 532 nm or KENKO BP-40 capable of conducting exposure with monochromic light of 405 nm was used as the optical filter. Thereafter, development was performed by immersing the exposed lithographic printing plate precursor in a developer having the composition shown below at 25˚C for 10 seconds, and the sensitivity (clear sensitivity) was calculated from the highest step number where the image was completely removed (as shown in Tables 1 and 2). The clear sensitivity as used herein means a minimum energy necessary for the formation of an image and as the value is smaller, the sensitivity is higher.

The exposure at 532 nm was conducted in Examples 7 to 12 and Comparative Examples 2 to 12, and the exposure at 405 was conducted in Examples 13 to 38 and Comparative Examples 13 to 24.

Composition of developer

| | |
|---|---|
| 1K Potassium silicate | 2.4 g |
| Potassium hydroxide | 0.2 g |
| Compound of formula (1) shown below | 5.0 g |
| Water | 91.3 g |
| 4Na salt of ethylenediaminetetraacetate | 0.1 g |

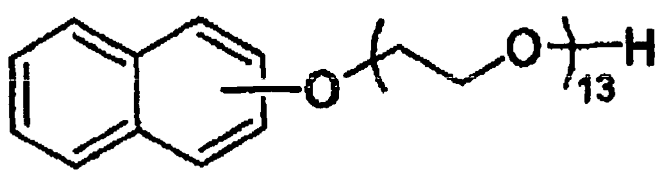
(1)

(1) Acid value obtained by NaOH titration: 1.08 meq/g Weight average molecular weight obtained by GPC measurement: $5.2 \times 10^4$

<As to the sensitivity in the difference of the exposure wavelength>

As to the sensitivity described above, the point to notice is described below. As the value of sensitivity is smaller, the sensitivity is higher. However, the sensitivities different in the exposure wavelength can not be compared.

The reason for this is that since an energy amount per photon is different based on the difference of exposure wavelength, as the wavelength becomes shorter, it is ordinarily possible to be sensitive even when the above-described exposure amount is small as simply recognized and thus, high sensitivity is obtained by the short wavelength exposure. Therefore, in Tables 1 and 2, comparison of the sensitivity in the different exposure conditions is meaningless and the evaluation of difference should be consistently made between the example and the comparative example under the same exposure conditions.

(Evaluation of preservation stability)

With the lithographic printing plate precursors subjected to the treatments under the conditions (fresh and after enforced preservation) shown below respectively, the clear sensitivities thereof were compared to evaluate the preservation stability.

(i) just after the preparation, the exposure and development were performed.
(ii) after the enforced preservation under conditions of 60°C for 10 days, the exposure and development were performed.

The clear sensitivity has the same meaning as described above. The difference between the clear sensitivity under condition (i) and the clear sensitivity under condition (ii) ((ii)/ (i)) was defined as a clear sensitivity ratio. Accordingly, the column indicated as "clear sensitivity ratio" in Tables 1 and 2 shows the evaluation result of the preservation stability. As the value is closer to 1, the change in the image-forming sensitivities in the fresh lithographic printing plate precursor and the lithographic printing plate precursor after the enforced preservation is smaller, and thus the preservation stability is higher. The results are shown in Table 1 and 2.

(Evaluation of development failure depending on layer-forming condition)

The composition for photosensitive layer described above was coated on the aluminum support, dried under each of the conditions described below and then the protective layer was provided thereon in the same manner as described above to prepare a plate sample. The plate sample was different from the lithographic printing plate precursor for use in the evaluation of sensitivity or the like and was prepared for the purpose of the evaluation of development failure.

<Drying conditions>

The drying were conducted under the following six conditions:

80°C: (1) 2 minutes, (2) 4 minutes
90°C: (3) 2 minutes, (4) 4 minutes
100°C: (5) 2 minutes, (6) 4 minutes

In the examples, the drying conditions are indicated using the numbers of (1) to (6).

<Evaluation of development failure>

The plate sample was developed by immersing it in a developer having the composition shown below at 25°C for 10 seconds and cleaned the surface thereof. Then, the surface developed was visually observed and the presence or absence of the development failure was determined. The case wherein the development failure was not completely recognized was denoted by ○, the case wherein the development failure was slightly recognized was denoted by Δ and case wherein the development failure was clearly recognized was denoted by ×. The results are shown in Tables 1 and 2.

(Evaluation of fog)

As for the lithographic printing plate precursor for exposing at 405 nm, in order to evaluate the safe light aptitude which is an index of workability, the lithographic printing plate precursor prepared was exposed under a yellow lamp (cutting wavelength of 500 nm or shorter) for 30 minutes before the image exposure and subsequently subjected to the image exposure and development in the same manner as described above. As a result of the visual observation, the case where the fog occurred (the lithographic printing plate precursor did not have the safe light aptitude) was indicated by × and the case where the fog did not occur (the lithographic printing plate precursor had the safe light aptitude) was indicated by O. The results are shown in Tables 1 and 2.

TABLE 1

| | Initiation System | | | Evaluation of Development Failure: Drying Conditions | Presence or Absence of Development Failure | Clear Sensitivity (mJ/cm$^2$) | Clear Sensitivity Ratio | Presence or Absence of Fog |
|---|---|---|---|---|---|---|---|---|
| | Sensitizing Dye (Xg) | Initiator Compound (Yg) | Co-Sensitizer (Zg) | | | | | |
| Example 1 | A1 (1.0) | T-1 (0.90) | R-1 (0.20) | (1) | O | 90 | 1.04 | - |
| Example 2 | A1 (1.0) | T-1(0.90) | R-1(0.20) | (2) | O | 90 | 1.04 | - |
| Example 3 | A1 (1.0) | T-1 (0.90) | R-1 (0.20) | (3) | O | 90 | 1.04 | - |
| Example 4 | A1(1.0) | T-1 (0.90) | R-1 (0.20) | (4) | O | 90 | 1.04 | - |
| Example 5 | A1 (1.0) | T-1 (0.90) | R-1 (0.20) | (5) | O | 90 | 1.04 | - |
| Example 6 | A1 (1.0) | T-1 (0.90) | R-1 (0.20) | (6) | Δ | 90 | 1.04 | |
| Example 7 | A2 (1.6) | T-5 (0.80) | R-1 (0.20) | (1) | O | 0.35 | 1.06 | - |
| Example 8 | A2 (1.6) | T-5 (0.80) | R-1 (0.20) | (2) | O | 0.35 | 1.06 | - |
| Example 9 | A2 (1.6) | T-6 (0.80) | R-1 (0.20) | (3) | O | 0.35 | 1.06 | - |
| Example 10 | A2 (1.6) | T-5 (0.80) | R-1 (0.20) | (4) | Δ | 0.35 | 1.06 | - |
| Example 11 | A2 (1.6) | T-6 (0.80) | R-1 (0.20) | (5) | Δ | 0.35 | 1.06 | - |
| Example 12 | A2 (1.6) | T-5 (0.80) | R-1 (0.20) | (6) | Δ | 0.35 | 1.06 | - |
| Example 13 | A3 (1.2) | T-2 (0.88) | R-1 (0.20) | (1) | O | 0.25 | 1.05 | O |
| Example 14 | A3 (1.2) | T-2(0.88) | R-1 (0.20) | (2) | O | 0.26 | 1.05 | O |
| Example 15 | A3 (1.2) | T-2 (0.88) | R-1 (0.20) | (3) | O | 0.26 | 1.05 | O |
| Example 16 | A3 (1.2) | T-2 (0.88) | R-1 (0.20) | (4) | Δ | 0.25 | 1.05 | O |
| Example 17 | A3 (1.2) | T-2 (0.88) | R-1 (0.20) | (5) | Δ | 0.25 | 1.05 | O |
| Example 18 | A3 (1.2) | T-2(0.88) | R-1 (0.20) | (6) | Δ | 0.25 | 1.05 | O |
| Example 19 | A3 (1.2) | T-1 (0.90) | R-1 (0.20) | (1) | ○ | 0.30 | 1.03 | ○ |
| Example 20 | A3 (1.2) | T-1 (0.90) | R-1 (0.20) | (2) | ○ | 0.30 | 1.03 | ○ |
| Example 21 | A3 (1.2) | T-1 (0.90) | R-1 (0.20) | (3) | ○ | 0.30 | 1.03 | ○ |
| Example 22 | A3 (1.2) | T-1 (0.90) | R-1 (0.20) | (4) | ○ | 0.30 | 1.03 | ○ |
| Example 23 | A3 (1.2) | T-1 (0.90) | R-1 (0.20) | (5) | ○ | 0.30 | 1.03 | ○ |

(continued)

| | Initiation System | | | Evaluation of Development Failure: Drying Conditions | Presence or Absence of Development Failure | Clear Sensitivity ($mJ/cm^2$) | Clear Sensitivity Ratio | Presence or Absence of Fog |
|---|---|---|---|---|---|---|---|---|
| | Sensitizing Dye (Xg) | Initiator Compound (Yg) | Co-Sensitizer (Zg) | | | | | |
| Example 24 | A3 (1.2) | T-1 (0.90) | R-1 (0.20) | (6) | Δ | 0.30 | 1.03 | ○ |
| Example 25 | A3 (1.2) | T-6 (1.06) | R-1 (0.20) | (1) | ○ | 0.27 | 1.05 | ○ |
| Example 26 | A3 (1.2) | T-6 (1.05) | R-1 (0.20) | (2) | ○ | 0.27 | 1.05 | ○ |
| Example 27 | A3 (1.2) | T-6 (1.05) | **R-1** (0.20) | (3) | ○ | 0.27 | 1.05 | ○ |
| Example 28 | A3 (1.2) | T-6 (1.05) | R-1 (0.20) | (4) | Δ | 0.27 | 1.05 | ○ |
| Example 29 | A3 (1.2) | T-6 (1.05) | R-1 (0.20) | (5) | Δ | 0.27 | 1.05 | O |
| Example 30 | A3 (1.2) | T-6 (1.05) | R-1 (0.20) | (6) | Δ | 0.27 | 1.05 | O |
| Example 31 | A3 (1.2) | T-9 (1.01) | R-1 (0.20) | (1) | O | 0.31 | 1.03 | O |
| Example 32 | A3 (1.2) | T-9(1.01) | R-1 (0.20) | (2) | O | 0.31 | 1.03 | O |
| Example 33 | A3 (1.2) | T-9 (1.01) | R-1 (0.20) | (3) | O | 0.31 | 1.03 | O |
| Example 34 | A3 (1.2) | T-9 (1.01) | R-1 (0.20) | (4) | O | 0.31 | 1.03 | O |
| Example 35 | A3 (1.2) | T-9(1.01) | R-1 (0.20) | (5) | Δ | 0.31 | 1.03 | O |
| Example 36 | A3(1.2) | T-9 (1.01) | R-1 (0.20) | (6) | Δ | 0.31 | 1.03 | O |
| Example 37 | A3 (1.2) | T-7 (0.82) | R-1 (0.20) | (3) | O | 0.25 | 1.03 | O |
| Example 38 | A3 (1.2) | T-7 (0.82) | R-1 (0.20) | (6) | Δ | 0.25 | 1.03 | O |

TABLE 2

| | Initiation System | | | Evaluation of Development Failure: Drying Conditions | Presence or Absence of Development Failure | Clear Sensitivity (mJ/cm$^2$ | Clear Sensitivity Ratio | Presence or Absence of Fog |
|---|---|---|---|---|---|---|---|---|
| | Sensitizing Dye (Xg) | Initiator Compound (Yg) | Co-Sensitizer (Zg) | | | | | |
| Comparative Example 1 | A1 (1.0) | H-1 (0.90) | R-1 (0.20) | (1) | Δ | 88 | 1.21 | - |
| Comparative Example 2 | A1 (1.0) | H-1 (0.90) | R-1 (0.20) | (2) | Δ | 88 | 1.21 | |
| Comparative Example 3 | A1 (1,0) | H-1 (0.90) | R-1 (0.20) | (3) | Δ | 88 | 1.21 | - |
| Comparative Example 4 | A1 (1.0) | H-1 (0.90) | R-1 (0.20) | (4) | × | 88 | 1.21 | - |
| Comparative Example 5 | A1 (1.0) | H-1 (0.90) | R-1 (0.20) | (5) | × | 88 | 1.21 | - |
| Comparative Example 6 | A1 (1.0) | H-1 (0.90) | R-1 (0.20) | (6) | × | 88 | 1.21 | - |
| Comparative Example 7 | A2 (1.6) | H-3 (0.75) | R-1 (0.20) | (1) | Δ | 0.38 | 1.35 | - |
| Comparative Example 8 | A2(1.6) | H-3 (0.15) | R-1 (0.20) | (2) | Δ | 0.38 | 1.35 | - |
| Comparative Example 9 | A2(1.6) | H-3 (0.75) | R-1 (0.20) | (3) | × | 0.38 | 1.35 | - |
| Comparative Example 10 | A2 (1.6) | H-3 (0.75) | R-1 (0.20) | (4) | × | 0.38 | 1.35 | - |
| Comparative Example 11 | A2 (1.6) | H-3 (0.75) | R-1 (0.20) | (5) | × | 0.38 | 1.35 | - |
| Comparative Example 12 | A2(1.6) | H-3 (0.75) | R-1. (0.20) | (6) | × | 0.38 | 1.35 | - |
| Comparative Example 13 | A3 (1.2) | H-6 (0.98) | R-1 (0.20) | (1) | Δ | 0.22 | 1.42 | ○ |

(continued)

| | Initiation System | | | Evaluation of Development Failure: Drying Conditions | Presence or Absence of Development Failure | Clear Sensitivity (mJ/cm$^2$ | Clear Sensitivity Ratio | Presence or Absence of Fog |
|---|---|---|---|---|---|---|---|---|
| | Sensitizing Dye (Xg) | Initiator Compound (Yg) | Co-Sensitizer (Zg) | | | | | |
| Comparative Example 14 | A3 (1.2) | H-6 (0.98) | R-1 (0,20) | (2) | × | 0.22 | 1.42 | O |
| Comparative Example 15 | A3 (1 .2) | H-6 (0.98) | R-1 (0.20) | (3) | × | 0.22 | 1.42 | ○ |
| Comparative Example 16 | A3 (1.2) | H-6 (0.98) | R-1 (0.20) | (4) | × | 0.22 | 1.42 | ○ |
| Comparative Example 17 | A3 (1.2) | H-6 (0.98) | R-1 (0.20) | (5) | × | 0.22 | 1.42 | ○ |
| Comparative Example 18 | A3 (1.2) | H-6 (0.98) | R-4 (0.20) | (6) | × | 0.22 | 1.42 | ○ |
| Comparative Example 19 | A3 (1.2) | H-1 (0.90) | R-1 (0.20) | (3) | Δ | 0.28 | 1.20 | ○ |
| Comparative Example 20 | A3 (1.2) | H-1 (0.90) | R-1 (0.20) | (6) | × | 0.28 | 1.20 | ○ |
| Comparative Example 21 | A3 (1.2) | H-8 (0.88) | R-2 (0.42) | (3) | × | 0.53 | 1.35 | O |
| Comparative Example 22 | A3 (1.2) | H-8 (0.88) | R-2 (0.42) | (6) | × | 0.53 | 1.35 | O |
| Comparative Example 23 | A3 (1.2) | H-7 (1.05) | R-2 (0.42) | (3) | ○ | 0.35 | 1.03 | × |
| Comparative Example 24 | A3 (1.2) | H-7 (1.05) | R-2 (0.42) | (6) | ○ | 0.35 | 1.03 | × |

From the results shown in Tables 1 and 2, it can be seen that the hexaarylbiimidazole compound according to the invention used in Examples 1 to 6 is an initiator exhibiting comparable or higher sensitivity and excellent preservation stability in comparison with Initiator H-1 for comparison used in Comparative Examples 1 to 6. Also, as is apparent from other examples, the initiation systems using the compound according to the invention are apparently prevented from the occurrence of development failure and exhibit good preservation stability in comparison with Comparative Examples. Further, in spite of the variation of exposure wavelength, the occurrence of development failure is improved. Thus, the hexaarylbiimidazole compound according to the invention is an excellent initiator in practical use. Moreover, it is clear that the hexaarylbiimidazole compound according to the invention does not cause the yellow lamp fog and is remarkably excellent in the workability in the plate-making of lithographic printing plate precursor as compared with the titanocene initiator used in Comparative Examples 23 and 24.

In the examples described above, the structures of the hexaarylbiimidazole compounds used are described in the specific examples thereof hereinbefore, and the structures of other compounds are shown below.

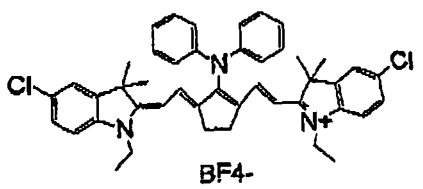

A1 (Exposure at 830 nm)

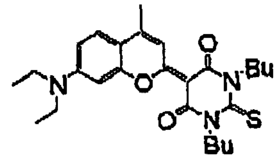

A2 (Exposure at 532 nm)

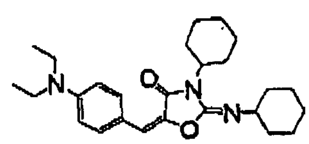

A3 (Exposure at 405 nm)

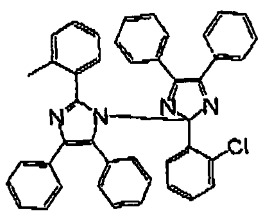

H-1

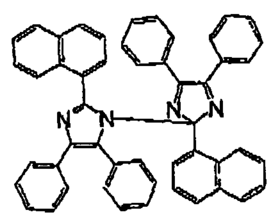

H-2

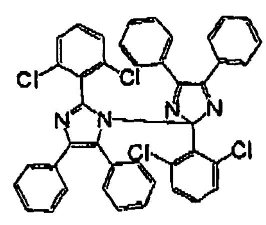

H-3

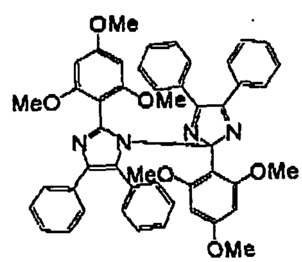

H-4

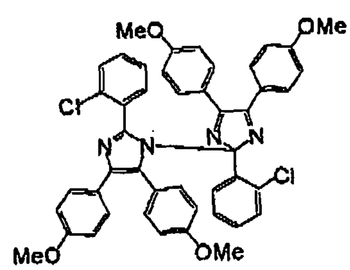

H-5

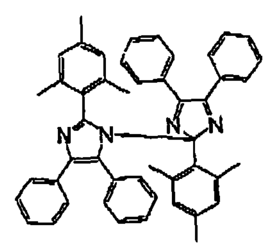

H-6

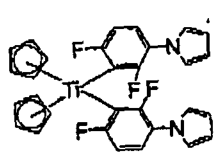

H-7

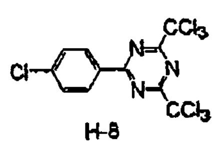

H-8

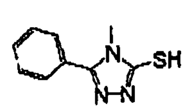

R-1

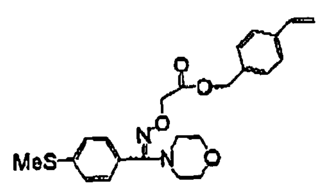

R-2

This application is based on Japanese Patent application JP 2005-79645, filed March 18, 2005, the entire content of which is hereby incorporated by reference, the same as if set forth at length.

## Claims

1. A photosensitive composition comprising:

a hexaarylbiimidazole compound represented by the following formula (I);
a sensitizing dye having an absorption maximum in a wavelength range of from 350 to 850 nm; and
an addition-polymerizable compound capable of reacting by at least one of a radical and an acid;

(I)

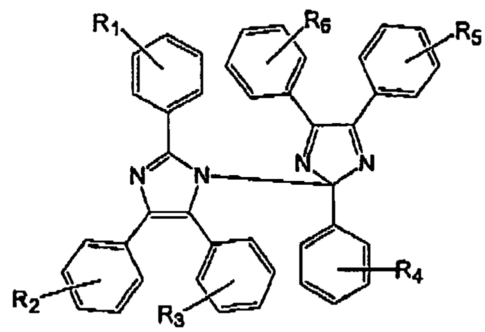

wherein $R_1$ to $R_6$ each independently represents a hydrogen atom or a monovalent non-metallic atomic group, or $R_1$ to $R_3$ or $R_4$ to $R_6$ may be combined with each other to form an aliphatic or aromatic ring, provided that aromatic rings substituted with $R_1$ or $R_4$ of 2-positions have electron donating groups having a negative Hammette's substituent constant on at least one of ortho-positions and metha-positions thereof respectively or aromatic rings substituted with $R_2$, $R_3$, $R_5$ or $R_6$ of 4-positions and 5-positions have electron withdrawing groups having a positive Hammette's substituent constant on at least one of metha-positions and para-positions thereof respectively.

2. The photosensitive composition as claimed in claim 1, wherein the hexaarylbiimidazole compound represented by the formula (I) has electron donating groups having a negative Hammette's substituent constant on at least one of ortho-positions and metha-positions of aromatic rings substituted with $R_1$ or $R_4$ of 2-positions respectively and electron withdrawing groups having a positive Hammette's substituent constant on at least one of metha-positions and para-positions of aromatic rings substituted with $R_2$, $R_3$, $R_5$ or $R_6$ of 4-positions and 5-positions respectively.

3. The photosensitive composition as claimed in claim 1, wherein the addition-polymerizable compound has at least one ethylenically unsaturated double bond.

4. The photosensitive composition as claimed in claim 2, wherein the addition-polymerizable compound has at least one ethylenically unsaturated double bond.

5. The photosensitive composition as claimed in claim 1, wherein the addition-polymerizable compound has at least two ethylenically unsaturated double bond.

6. The photosensitive composition as claimed in claim 2, wherein the addition-polymerizable compound has at least two ethylenically unsaturated double bond.

7. The photosensitive composition as claimed in claim 1, further comprising a binder polymer.

8. The photosensitive composition as claimed in claim 1, further comprising a binder polymer.

9. An image-recording material comprising a support and a photosensitive layer containing the photosensitive composition as claimed in claim 1.

10. An image-recording method comprising conducting scanning exposure to an image-recording material comprising a support and a photosensitive layer containing the photosensitive composition as claimed in claim 1 with a laser light source having a wavelength of from 350 to 450 nm.

European Patent Office

# EUROPEAN SEARCH REPORT

Application Number
EP 06 00 5628

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | JP 2002 287344 A (FUJI PHOTO FILM CO., LTD.) 3 October 2002 (2002-10-03)<br>* page 69; example 6; table 17 *<br>* page 70, compound X-6 *<br>----- | 1,3,5, 7-10 | INV. G03F7/031 |
| X | JP 11 279403 A (HITACHI CHEM. CO., LTD.) 12 October 1999 (1999-10-12)<br>* page 17; examples 3,4 *<br>----- | 1,3,5, 7-9 | |

TECHNICAL FIELDS SEARCHED (IPC)

G03F

The present search report has been drawn up for all claims

2

| Place of search | Date of completion of the search | Examiner |
|---|---|---|
| The Hague | 24 July 2006 | Dupart, J.-M. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT ON EUROPEAN PATENT APPLICATION NO. EP 06 00 5628

This annex lists the patent family members relating to the patent documents cited in the above-mentioned European search report.
The members are as contained in the European Patent Office EDP file on
The European Patent Office is in no way liable for these particulars which are merely given for the purpose of information.

24-07-2006

| Patent document cited in search report | Publication date | Patent family member(s) | Publication date |
|---|---|---|---|
| JP 2002287344 A | 03-10-2002 | NONE | |
| JP 11279403 A | 12-10-1999 | NONE | |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- US 4708925 A
- JP 8276558 A
- US 2850445 A
- JP 4420189 B
- JP 2001133969 A
- JP 3713034 B
- JP 62143044 A
- JP 59024147 B
- JP 6433104 A
- JP 6456767 A
- JP 2001714 A
- JP 2226148 A
- JP 2226149 A
- JP 4028499 B
- JP 46042363 B
- JP 2063053 A
- JP 2085858 A
- JP 2216154 A
- JP 57010605 A
- JP 2030321 B
- JP 1287105 A
- JP 62031844 A
- JP 62031848 A
- JP 62143043 A
- JP 59028325 B
- JP 61009621 B
- JP 2179643 A
- JP 2244050 A
- JP 59028326 B
- JP 59089803 A
- JP 8129257 A
- JP 8334897 A
- JP 58125246 A
- JP 59084356 A
- JP 59202829 A
- JP 60078787 A
- GB 434875 A
- US 5156938 A
- US 3881924 A
- JP 57142645 A
- US 4327169 A
- JP 58181051 A
- JP 58220143 A
- JP 59041363 A
- JP 59084248 A
- JP 59084249 A
- JP 59146063 A
- JP 59146061 A
- JP 59216146 A
- US 4283475 A
- JP 5013514 B
- JP 5019702 B
- US 4756993 A
- EP 916513 A
- JP 10079912 A
- JP 11338131 A
- JP 6269047 A
- JP 2001033952 A
- JP 46027926 B
- JP 51047334 B
- JP 57196231 A
- JP 59005240 A
- JP 59005241 A
- JP 1165613 A
- JP 54021726 B
- JP 48041708 B
- JP 51037193 A
- JP 2032293 B
- JP 2016765 B
- JP 58049860 B
- JP 56017654 B
- JP 62039417 B
- JP 62039418 B
- JP 63277653 A
- JP 63260909 A
- JP 1105238 A
- JP 48064183 A
- JP 49043191 B
- JP 52030490 B
- JP 46043946 B
- JP 1040337 B
- JP 1040336 B
- JP 2025493 A
- JP 61022048 A
- JP 59044615 A
- JP 54034327 B
- JP 58012577 B
- JP 54025957 B
- JP 54092723 A
- JP 59053836 A
- JP 59071048 A
- JP 7120040 B
- JP 7120041 B
- JP 7120042 B
- JP 8012424 B
- JP 63287944 A
- JP 63287947 A
- JP 1271741 A

- JP 13312062 A
- JP 11171909 A
- JP 9236913 A
- JP 5045885 A
- JP 48018327 B
- JP 54063902 A
- JP 47005125 B
- US 3658662 A
- JP 46027481 B
- JP 52058602 A
- JP 52030503 A
- JP 56028893 A
- JP 7159983 A
- US 3055295 A
- JP 56013168 A
- JP 9080744 A
- JP 8507727 A
- US 3458311 A
- JP 55049729 A
- JP 57007427 B
- US 3375171 A
- US 3615480 A
- JP 50026601 A
- JP 58054341 A
- JP 56039464 B
- JP 56042860 B
- JP 2002202616 A
- JP 2005079645 A

**Non-patent literature cited in the description**


- **BRUCE M. MONROE et al.** *Chemical Reviews,* 1993, vol. 93, 435
- **R. S. DAVIDSON.** *Journal of Photochemistry and Photobiology A: Chemistry,* 1993, vol. 73, 81
- Carbon Black Binran. Carbon Black Kyokai, 05 April 1995, 12
- Senryo Binran. The Society of Synthetic Organic Chemistry, Japan, 1970
- Saishin Ganryo Binran. Pigment Technology Society of Japan, 1977
- Saishin Ganryo Oyou Gijutsu. CMC Publishing Co., Ltd, 1986
- Insatsu Ink Gijutsu. CMC Publishing Co., Ltd, 1984
- Kinzoku Sekken no Seishitsu to Oyo. Saiwai Shobo
- Saishin Ganryo Oyo Gijutsu. CMC Publishing Co., Ltd, 1986
- *Nippon Secchaku Kyokaishi,* 1984, vol. 20 (7), 300-308